# EUROPEAN PATENT APPLICATION

(11) **EP 4 697 894 A1**
(43) Date of publication of application: **18.02.2026**
(21) Application number: 25193449.3
(22) Date of filing: 01.08.2025
(51) Int. Cl.: H10D 84/01, H10D 30/01, H10D 30/00, H10D 84/83, H10D 84/85, H10D 88/00, H10D 62/00

(54) **INTEGRATED CIRCUIT DEVICES INCLUDING STACKED TRANSISTORS HAVING INDEPENDENTLY ADJUSTABLE GATES, CHANNELS, AND INNER SPACERS AND METHODS OF FORMING THE SAME**

(30) Priority: 14.08.2024 US 202463683002 P; 10.02.2025 US 202519049440
(71) Applicant: Samsung Electronics Co., Ltd., Suwon-si, Gyeonggi-do 16677 (KR)
(72) Inventor: PARK, Beomjin, San Jose, CA 95134 (US); SHIN, Jongmin, San Jose, CA 95134 (US); PARK, Inwon, San Jose, CA 95134 (US); CHO, Edward Namkyu, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

An integrated circuit device (100) includes a stacked transistor structure (101) on a substrate (106). The stacked transistor structure (101) includes a first transistor (102) and a second transistor (104) stacked on the first transistor (102). Each of the first and second transistors (102, 104) includes a plurality of channel patterns (108, 110) that extend between source/drain regions (114, 116) in a first direction (D1) and are alternately stacked with gate patterns (107) in a second direction (D3). For at least one of the first and second transistors (102, 104), respective lengths of the channel patterns (108, 110), the gate patterns (107), and/or inner spacers (112) at opposing ends of the gate patterns (107) differ along the first direction. Related devices and fabrication methods are also discussed.

## Description

### FIELD

The present disclosure relates to integrated circuit devices.

### BACKGROUND

Integrated circuit devices may utilize stacked transistors to increase density and improve performance. In some instances, the stacked transistors may be complementary to each other (e.g., complementary metal-oxide-semiconductor (CMOS) transistors). For example, a Complementary-FET (CFET) layout may include multiple vertically stacked pairs of gate-all-around field effect transistors (GAAFETs), with P-type GAAFETs on one-level, N-type GAAFETs on another level (i.e., above or below), and shared gates, where each shared gate extends between and wraps around the channel patterns of the stacked pair of N-type and P-type GAAFETs. In such structures, the source/drain regions of the lower GAAFET are electrically isolated from the source/drain regions of the upper GAAFET by dielectric layers. The gates, channel patterns, and isolation structures (including spacers between the gates and source/drain regions) may be similar in dimensions between the upper and lower devices of the stacked transistors.

### SUMMARY

According to some embodiments, an integrated circuit device includes a substrate; and a stacked transistor structure on the substrate. The stacked transistor structure includes a first transistor and a second transistor stacked on the first transistor. Each of the first and second transistors includes one or more channel patterns that extend between source/drain regions in a first direction and are alternately stacked with one or more gate patterns in a second direction. For at least one of the first and second transistors, respective lengths of the channel patterns and the gate patterns differ along the first direction.

In some embodiments, the at least one of the first and second transistors is the second transistor, and the respective lengths of the channel patterns of the second transistor are shorter than that of the channel patterns of the first transistor.

In some embodiments, for the at least one of the first and second transistors, the respective length of at least one of the channel patterns is shorter than that of ones of the channel patterns thereabove and therebelow in the second direction.

In some embodiments, the at least one of the first and second transistors comprises inner spacers between opposing ends of the gate patterns and the source/drain regions thereof in the first direction. For the at least one of the first and second transistors, respective lengths of the inner spacers differ along the first direction.

In some embodiments, the at least one of the first and second transistors is the second transistor, and the respective lengths of the inner spacers of the second transistor are shorter than that of inner spacers of the first transistor.

In some embodiments, for the at least one of the first and second transistors, the respective length of at least one of the inner spacers is shorter than that of ones of the inner spacers thereabove and therebelow in the second direction.

In some embodiments, for the at least one of the first and second transistors, respective lengths of the channel patterns and the gate patterns differ along the first direction.

In some embodiments, the at least one of the first and second transistors is the second transistor, and the respective lengths of the gate patterns of the second transistor are shorter than that of the gate patterns of the first transistor.

In some embodiments, for the at least one of the first and second transistors, the respective length of at least one of the gate patterns is shorter than that of ones of the gate patterns thereabove and therebelow in the second direction.

In some embodiments, the channel patterns, the gate patterns, and the source/drain regions are lower nanosheets, lower gate patterns, and lower source/drain regions of the first transistor, and upper nanosheets, upper gate patterns, and upper source/drain regions of the second transistor.

In some embodiments, the lower source/drain regions are of a first conductivity type, and the upper source/drain regions are of a second conductivity type that is opposite to the first conductivity type.

According to some embodiments, a method of forming an integrated circuit device includes forming a stacked transistor structure on a substrate. The stacked transistor structure includes a first transistor and a second transistor stacked on the first transistor. Each of the first and second transistors includes one or more channel patterns that extend between source/drain regions in a first direction and are alternately stacked with one or more gate patterns in a second direction. For at least one of the first and second transistors, respective lengths of the channel patterns and the gate patterns differ along the first direction.

In some embodiments, forming the stacked transistor structure includes forming a plurality of channel layers that are stacked on a substrate; and performing at least one etching process on the plurality of channel layers to form the channel patterns of the at least one of the first and second transistors with the respective lengths that differ along the first direction.

In some embodiments, performing the at least one etching process includes performing a tapered etching process on the plurality of channel layers such that the respective length of at least one of the channel patterns of the second transistor is shorter than that of at least one of the channel patterns of the first transistor by about 10 percent or more.

In some embodiments, performing the at least one etching process includes performing a first etching process on the plurality of channel layers; and performing a bowl etching process on the channel patterns of the at least one of the first and second transistors such that the respective length of at least one of the channel patterns is shorter than that of ones of the channel patterns thereabove and therebelow in the second direction.

In some embodiments, the at least one of the first and second transistors is the second transistor, and the method further includes, after performing the first etching process, epitaxially growing the source/drain regions of the first transistor at the opposing ends of the channel patterns thereof; forming an etch stop layer on the source/drain regions of the first transistor before performing the bowl etching process on the channel patterns of the second transistor; and after performing the bowl etching process, epitaxially growing the source/drain regions of the second transistor at the opposing ends of the channel patterns thereof.

In some embodiments, the gate patterns of the second transistor comprise sacrificial gate patterns having inner spacers at opposing ends thereof, and, responsive to the bowl etching process, a respective length of at least one of the inner spacers is shorter than that of ones of the inner spacers thereabove and therebelow in the second direction.

In some embodiments, the gate patterns of the second transistor include sacrificial gate patterns that are free of inner spacers at opposing ends thereof, and wherein, responsive to the bowl etching process, the respective length of at least one of the sacrificial gate patterns is shorter than that of ones of the sacrificial gate patterns thereabove and therebelow in the second direction.

In some embodiments, the channel patterns, the gate patterns, and the source/drain regions include lower nanosheets, lower gate patterns, and lower source/drain regions of the first transistor, and upper nanosheets, upper gate patterns, and upper source/drain regions of the second transistor, and the lower source/drain regions are of a first conductivity type, while the upper source/drain regions are of a second conductivity type that is opposite to the first conductivity type.

According to some embodiments, a method of forming an integrated circuit device includes forming a plurality of channel layers and sacrificial layers that are alternately stacked on a substrate; performing a first etching process on the plurality of channel layers and sacrificial layers to form channel patterns and sacrificial gate patterns, the channel patterns extending in a first direction and alternately stacked with the sacrificial gate patterns therebetween in a second direction; and performing a second etching process on at least one of a first subset of the channel patterns corresponding to a first transistor or a second subset of the channel patterns corresponding to a second transistor that is stacked on the first transistor. Responsive to the second etching process, respective lengths of the channel patterns of the at least one of the first subset or the second subset differ along the first direction.

In some embodiments, the at least one of the first subset or the second subset is the second subset, and the method further includes, after performing the first etching process, epitaxially growing source/drain regions of the first transistor at the opposing ends of the channel patterns of the first subset; forming an etch stop layer on the source/drain regions of the first transistor before performing the second etching process on the channel patterns of the second subset; and after performing the second etching process, epitaxially growing source/drain regions of the second transistor at the opposing ends of the channel patterns of the second subset. Responsive to the second etching process, the respective length of at least one of the channel patterns of the second subset is shorter than that of ones of the channel patterns of the second subset thereabove and therebelow in the second direction.

In some embodiments, the sacrificial gate patterns between the channel patterns of the second subset include inner spacers at opposing ends thereof, and, responsive to the second etching process, a respective length of at least one of the inner spacers is shorter than that of ones of the inner spacers thereabove and therebelow in the second direction.

In some embodiments, the sacrificial gate patterns between the channel patterns of the second subset are free of inner spacers at opposing ends thereof, and, responsive to the second etching process, the respective length of at least one of the sacrificial gate patterns is shorter than that of ones of the sacrificial gate patterns thereabove and therebelow in the second direction.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the present disclosure, and be protected by the accompanying claims.

### BRIEF DESCRIPTION OF THE DRAWINGS

FIGS. 1A and 1B are schematic cross-sectional views illustrating various configurations of semiconductor integrated circuit devices according to some embodiments of the present disclosure.
FIGS. 2A, 2B, and 2C are schematic cross-sectional views illustrating various configurations of semiconductor integrated circuit devices according to some embodiments of the present disclosure.
FIGS. 3A, 3B, 3C, 3D, 3E, 3F, 3G, 3H, and 3I are schematic cross-sectional views illustrating methods of fabricating semiconductor integrated circuit devices according to some embodiments of the present disclosure.
FIGS. 4A, 4B, 4C, 4D, 4E, and 4F are schematic cross-sectional views illustrating methods of fabricating semiconductor integrated circuit devices according to further embodiments of the present disclosure.
FIGS. 5A, 5B, 5C, 5D, 5E1, 5E2, 5F1, and 5F2 are schematic cross-sectional views illustrating methods of fabricating semiconductor integrated circuit devices according to further embodiments of the present disclosure.
FIG. 6 is a flowchart illustrating methods of fabricating semiconductor integrated circuit devices according to some embodiments of the present disclosure.
FIG. 7 is a flowchart illustrating methods of fabricating semiconductor integrated circuit devices according to further embodiments of the present disclosure.
FIGS. 8A and 8B are schematic cross-sectional views illustrating semiconductor integrated circuit devices according to a comparative example.

### DETAILED DESCRIPTION OF EMBODIMENTS

In embodiments described herein, a stacked transistor structure may include a first transistor and a second transistor. The first transistor may be a first type of transistor (e.g., a n-type metal-oxide-semiconductor (NMOS) transistor) and the second transistor may be a second type of transistor (e.g., a p-type metal-oxide-semiconductor (PMOS) transistor). The first and second types of transistors may be complementary to each other (e.g., CMOS transistors), and in some embodiments the stacked transistor may be or may include a stack of CMOS transistors. The first and second transistors may be stacked in any order (e.g., with the first transistor on top of the second transistor, or the second transistor on top of the first transistor), resulting in a stack comprising a top device (also referred to herein as an upper device or upper transistor, relative to an underlying substrate) and a bottom device (also referred to herein as a lower device or lower transistor, relative to the underlying substrate). Gates, channels, source/drain regions, and inner spacers of the upper and lower devices may likewise be referred to by the terms "upper" and "lower" (e.g., upper gates/lower gates, upper channels/lower channels, upper source/drain regions/lower source/drain regions, and upper inner spacers/lower inner spacers).

Some embodiments of the present disclosure may arise from realization that gates, source/drain (S/D) regions, and inner spacers (between the gates and the S/D regions) of both the upper device and the lower device of some stacked transistors may typically be formed concurrently by the same process. That is, upper gates and lower gates may be concurrently formed by the same process; upper channel regions and lower channel regions may be concurrently formed by the same process; and upper inner spacers and lower inner spacers may be concurrently formed by the same process.

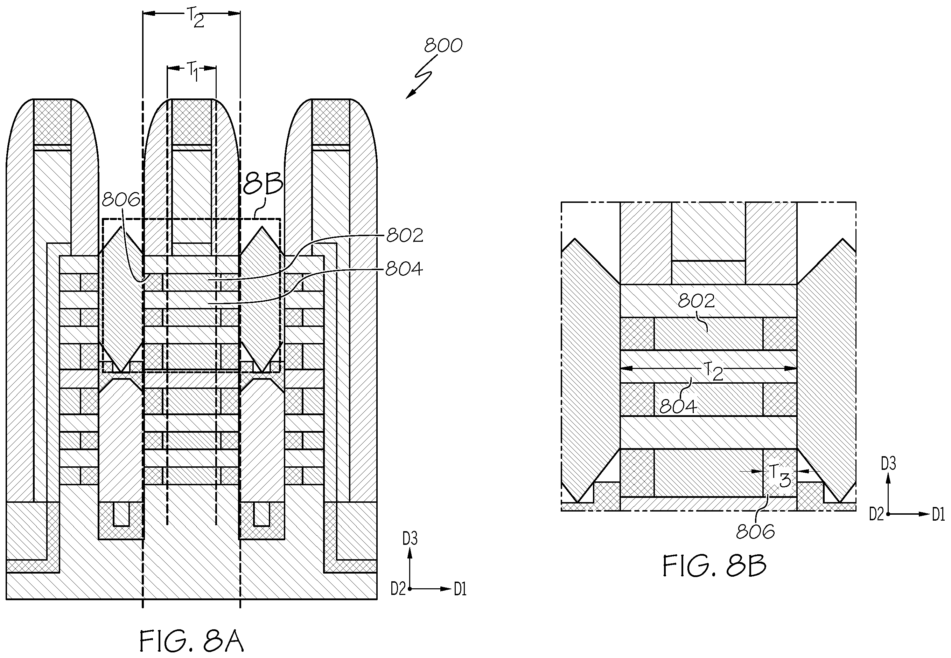

As a result, the lengths of gates, channels, and the inner spacers (as measured along the direction of extension of the channels between the source/drain (S/D) regions) of the upper device and the lower device may not be independently (e.g., individually) adjustable. For example, the gates, channels, and inner spacers of some upper and lower devices (including uppermost, lowermost, and intervening ones of the gates, channels, and inner spacers of each device) may have substantially the same lengths, respectively. As a more specific example and referring to semiconductor device 800 illustrated in FIGS. 8A-8B (where FIG. 8B is an enlarged view of region 8B in FIG. 8A), the length in a first direction D1 of each of the gate patterns 802 may be T1, the length in the first direction D1 of each of the channels 804 may be T2, and the length in the first direction D1 of each of the inner spacers 806 may be T3. Also, the lengths of the channels and/or thicknesses of inner spacers of (on) floors in the upper device and the lower device may be substantially the same. Herein, the length of a channel may refer to a distance of extension of the channel between S/D regions at opposing ends of the channel (i.e., a distance of separation between the S/D regions); the length of a gate may refer to a distance of extension of a gate electrode along the channel; and the length of an inner spacer may refer to a distance of extension of the inner spacer between a corresponding gate electrode and a corresponding S/D region along the direction of extension of the channel. The lengths may also be referred to as widths or thicknesses, depending on orientation of the devices or sublayers thereof.

Embodiments of the present disclosure provide integrated circuit devices having stacked transistor structures (such as a 3D stacked FET (3DSFET) in a CMOS configuration) with gates, channels, and/or inner spacers that are asymmetric (e.g., with different lengths or thicknesses) between upper and lower devices, and/or between components of the upper or lower devices. For example, the lower gates may be formed longer than the upper gates (or vice versa); the lower channels may be formed longer than the upper channels (or vice versa); and/or the lower inner spacers may be formed longer than the upper inner spacers (or vice versa).

Some embodiments may provide the upper and lower devices of a stacked transistor with gate/channel/inner spacer lengths that can be independently controlled, for example, by forming the profile of the stacked transistor (e.g., 3DSFET) with a tapered shape, e.g., as formed by a tapered or isotropic etch process. For example, the profile may have a trapezoidal shape in a cross-sectional view. In some examples, the uppermost gate among the lower gates may be longer than the lowermost gate among the upper gates; the uppermost channel among the lower channels may be longer than the lowermost channel among the upper channels; and/or the uppermost inner spacer among the lower inner spacers may be longer than the lowermost inner spacer among the upper inner spacers. That is, each of the upper gates and each of the lower gates may have different lengths; each of the upper channels and each of the lower channels may have different lengths; and/or each of the upper inner spacers and each of the lower inner spacers may have different lengths.

Some embodiments may provide the upper and lower devices of a stacked transistor with gate/channel/inner spacer lengths that can be independently controlled, for example, by forming the upper S/D regions and/or the lower S/D regions by using a bowl etch process (with plasma) and epitaxial growth of the S/D regions thereafter. In some embodiments, the S/D regions (e.g., the upper S/D regions and/or the lower S/D regions) may be convex toward the channels and the inner spacers because of the characteristics of the bowl etch process. As a result, the middle gates may include the shortest gate, the middle channels may include the shortest channel, and the middle inner spacers may include the shortest inner spacer. For example, middle ones of the upper gates may include the shortest upper gate; middle ones of the lower gates may include the shortest lower gate; middle ones of the upper channels may include the shortest upper channel; middle ones of the lower channels may include the shortest lower channel; middle ones of the upper inner spacers may include the shortest upper inner spacer; and/or middle ones of the lower inner spacers may include the shortest lower inner spacer. When the bowl etch process is applied to the upper device, the upper inner spacers, upper gates, and/or upper channels may be shorter than the lower inner spacers, lower gates, or lower channels, respectively. When the bowl etch process is applied to the lower device, the lower inner spacers, lower gates, and/or lower channels may be shorter than the upper inner spacers, upper gates, or upper channels, respectively.

Therefore, the gate length, channel length, and inner spacer length (or thickness) of the upper device may be shorter or longer than those of the lower device (depending on whether the bowl etch is applied to the upper or lower device, and the amount or duration of the bowl etch). In some embodiments, some of the inner spacers may be omitted or completely replaced by the S/D regions. Even if the inner spacers are not present, the shortest upper channel may be included in the middle ones of the upper channels and the shortest lower channel may be included in the middle ones of the lower channels.

That is, embodiments of the present disclosure may provide integrated circuit devices having stacked transistor structures in which the gate length of the upper device is shorter than that of the lower device (and may vary within each device stack), with or without the presence of inner spacers. In embodiments where inner spacers are present, the gate length and/or inner spacer length (along the direction of the channel length) of the upper device may be shorter or longer than that of the lower device (and/or may differ within each device stack); the length of the inner spacers (along the direction of the channel length) in the upper or lower device may be thinnest (or narrowest) in the middle of each device stack; and/or the channel lengths of the upper or lower device may be shortest in the middle of each device stack. In embodiments where inner spacers are absent or omitted in at least one of the upper or lower devices (or replaced by source/drain regions), the gate lengths and/or channel lengths of the upper or lower device may be shortest in the middle of each device stack.

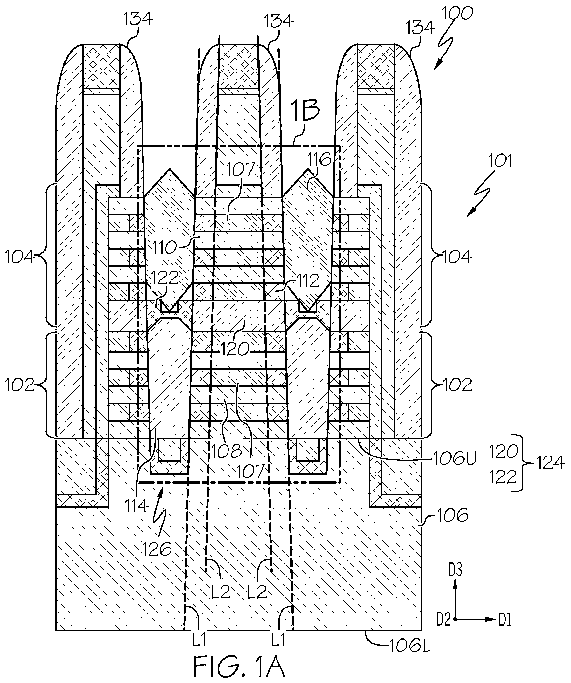

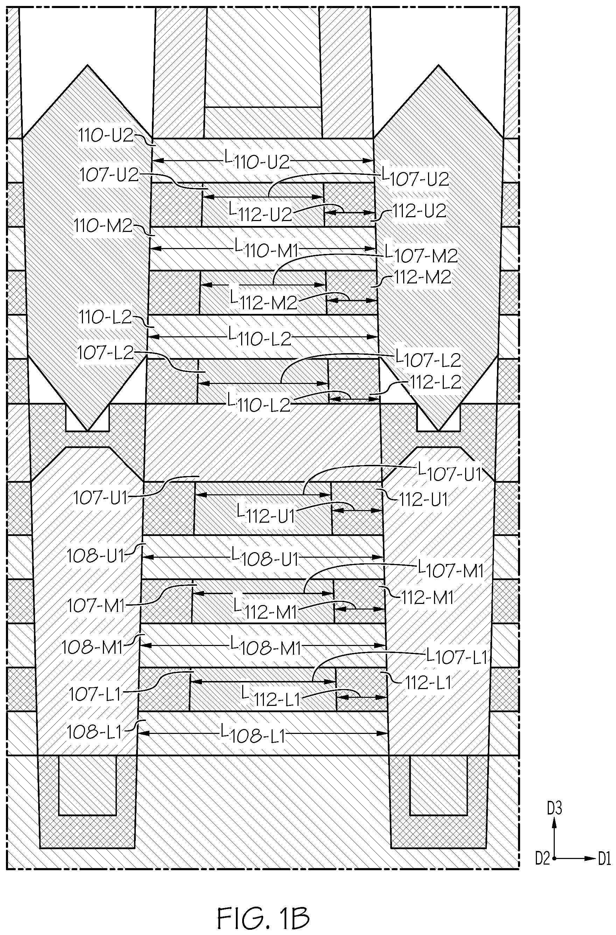

FIGS. 1A and 1B are cross-sectional views illustrating an example configuration of a semiconductor integrated circuit device 100 according to some embodiments of the present disclosure. As shown in FIGS. 1A-1B (where FIG. 1B is an enlarged view of region 1B in FIG. 1A), an integrated circuit device includes a stacked transistor structure 101 including first and second transistors 102, 104 vertically stacked on a substrate 106. The first transistor 102 includes at least one first channel pattern 108 (e.g., at least one lower nanosheet) between conductive gate patterns 107. The second transistor 104 includes at least one second channel pattern 110 (e.g., at least one upper nanosheet) between conductive gate patterns 107. In the example of FIGS. 1A-1B, multiple second channel patterns 110 are stacked on multiple first channel patterns 108, with the gate patterns 107 alternatingly stacked between the channel patterns 108, 110 (e.g., lower gate patterns alternatingly stacked between the first channel patterns 108 and upper gate patterns alternatingly stacked between the second channel patterns 110), but embodiments of the present disclosure may include fewer or more channel patterns 108, 110 than shown. The channel patterns 108, 110 may be provided by semiconductor materials, such as silicon (Si). A gate contact structure may be electrically connected to the gate patterns 107.

The stacked transistor structure 101 may further include inner spacers 112 (e.g., formed of insulating or dielectric materials, for example, SiOCN or other low-k dielectric material) that are between adjacent ones of the first channel patterns 108 and/or second channel patterns 110, and additional semiconductor (e.g., Si) and insulator (e.g., SiN, SiO) layers stacked on the channel patterns 108, 110. It should be understood that the inner spacers 112 may be omitted from the first and/or second transistors 102, 104 in some embodiments. As an example, the inner spacers 112 may be between adjacent ones of the first channel patterns 108, and the second channel patterns 110 may be free of the inner spacers 112 therebetween. As another example, the inner spacers 112 may be between adjacent ones of the second channel patterns 110, and the first channel patterns 108 may be free of the inner spacers 112 therebetween.

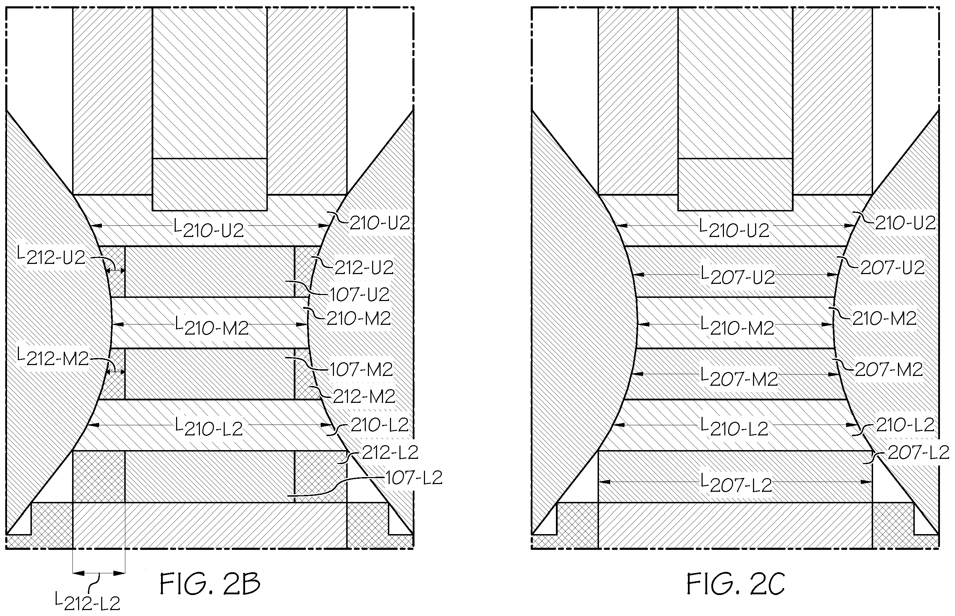

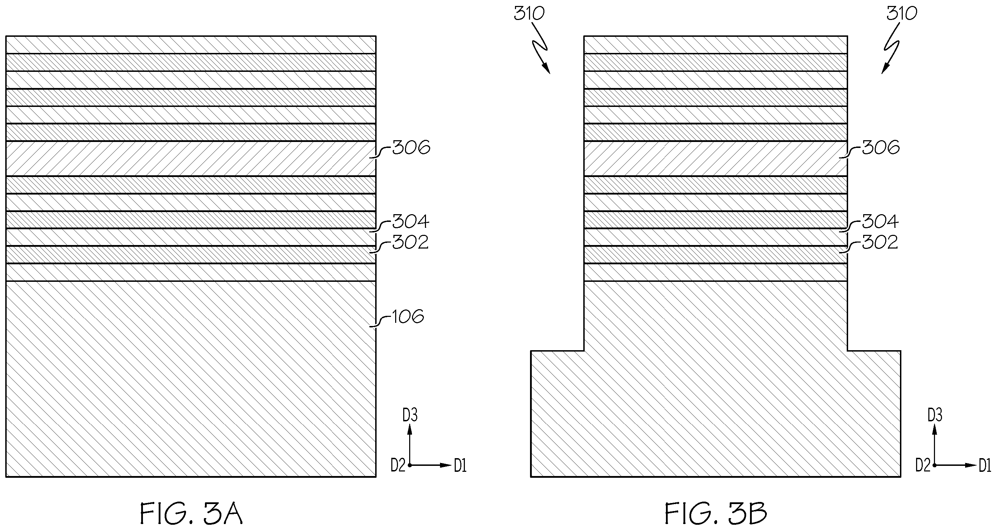

First (or lower) source/drain regions 114 of the first transistor 102 having a first conductivity type (e.g., n-type) are provided on opposing sides (also referred to herein as opposing ends) of the first channel patterns 108, and second (or upper) source/drain regions 116 of the second transistor 104 having a second conductivity type that is opposite to the first conductivity type (e.g., p-type) are provided on opposing sides or ends of the second channel patterns 110. In some embodiments, the first source/drain regions 114 may include a same material or material composition as the first channel pattern 108 and the substrate 106. For example, the first channel patterns 108 and the first source/drain regions 114 may be implemented as silicon layers. In some embodiments, the second source/drain regions 116 may include a different material or material composition than the first source/drain regions 114. For example, the second channel patterns 110 may be implemented as silicon germanium (SiGe) layers. In some embodiments, the first and second source/drain regions 114, 116 have a trapezoidal shape in a cross-sectional view and are formed by a tapered or isotropic etch process, as described below in further detail with reference to FIGS. 3A-3I. In some embodiments, the first and second source/drain regions 114, 116 may extend between portions of the conductive gate patterns 107 and directly contact the first and second channel patterns 108, 110 when the inner spacers 112 are omitted, as described below in further detail with reference to FIG. 2C. The first and second channel patterns 108, 110 may extend in the first direction D1 and between the source/drain regions 114, 116, respectively.

Source/drain contact structures may be provided on and electrically connected to the first and second source/drain regions 114, 116. The source/drain contact structures may be electrically isolated or separated from each other and the gate contact structure.

In the example of FIGS. 1A-1B, the first (lower) transistors 102 and second (upper) transistors 104 have complementary conductivity types, e.g., to provide a CMOS device. In particular, the first transistors 102 may have a first conductivity type (e.g., n-type), while the second transistors 104 may have a second conductivity type (e.g., p-type) that is opposite to the first conductivity type, or vice versa. That is, stacked transistor structures 101 according to embodiments of the present disclosure are not limited to particular orientations of transistors having the different conductivity types. Moreover, the first and second transistors 102 and 104 may have the same conductivity type (e.g., both the first and second transistors 102 and 104 may be n-type, or both the first and second transistors 102 and 104 may be p-type) in some embodiments. Also, while illustrated with reference to first and second transistors 102 and 104, it will be understood that stacked transistor structures 101 according to embodiments of the present disclosure are not limited to a two-transistor arrangement, and may include additional transistors (e.g., third transistors, fourth transistors, etc.) that are vertically stacked on the substrate 106.

Still referring to FIGS. 1A-1B, first isolation patterns 120 may include insulating (e.g., oxidized) materials and may be provided between the first channel patterns 108 and the second channel patterns 110. Second isolation patterns 122 may be provided on the upper surface of the first source/drain regions 114 and lower surfaces of the second source/drain regions 116. The first and second isolation patterns 120 and 122 between the second source/drain regions 116 and the first source/drain regions 114 collectively define device isolation patterns 124 that provide electrical isolation between the first and second transistors 102 and 104. The device isolation patterns 124 including the first isolation patterns 120 and second isolation patterns 122 as described herein may effectively provide electrical isolation between the first and second transistors 102 and 104 even as CPP is reduced and/or A/R is increased. Although not shown, it should be understood that an additional isolation pattern may be provided on the upper surface of the second source/drain regions 116.

As also shown in FIGS. 1A-1B, insulating regions 126 (e.g., leakage protection regions) are provided on the substrate 106 adjacent the opposing sides of the first channel pattern, such that the first source/drain regions 114 are between the second source/drain regions 116 and the insulating regions 126. The insulating regions 126 may be implemented by one or more insulating patterns formed in or on the substrate 106. For example, in some embodiments as described in greater detail below with reference to FIGS. 3A to 3F, FIGS. 4A to 4F, and FIGS. 5A to 5H2, the substrate 106 may include recessed surfaces adjacent the opposing sides of the first channel patterns 108, and the insulating patterns may at least partially fill the recessed surfaces to provide insulating regions 126. In some embodiments, the insulating patterns may be oxide-based (e.g., silicon oxide) patterns or nitride-based (e.g., silicon nitride) patterns. Other insulating materials (e.g., SiO₂, SiON, SiOCN, SiBCN, SiCN, etc.) may also be used as the insulating patterns, such that the insulating regions 126 may be the same material or may be a different material than the first and/or second isolation patterns 120 and/or 122. The insulating regions 126 are thereby provided between the first source/drain regions 114 and the substrate 106.

In some embodiments, the inner spacers 112, the first and second channel patterns 108, 110, and the conductive gate patterns 107 extend in a first direction D1 that is parallel with a lower surface 106L of the substrate 106. For at least one of the first and second transistors 102, 104, respective lengths of the channel patterns 108, 110, the gate patterns 107, and/or the inner spacers 112 at opposing ends of the gate patterns 107 differ along the first direction D1.

In some embodiments, a length in the first direction D1 of each of the first channel patterns 108 may be different. As an example, the first channel patterns 108 may include a lower first channel pattern 108-L1, an upper first channel pattern 108-U1, and a middle first channel pattern 108-M1 between the lower and upper first channel patterns 108-L1 and 108-U1. Each of the lower first channel pattern 108-L1, the middle first channel pattern 108-M1, and the upper first channel pattern 108-U1 may have a different length in the first direction D1. As shown in FIG. 1B, the lower first channel pattern 108-L1 has a length L_{108-L1} in the first direction D1, the middle first channel pattern 108-M1 has a length L_{108-M1} in the first direction D1 that is shorter or less than the length L_{108-L1} of the lower first channel pattern 108-L1, and the upper first channel pattern 108-U1 has a length L_{108-U1} in the first direction D1 that is shorter or less than the length L_{108-M1} of the middle first channel pattern 108-M1. That is, the lengths in the first direction D1 of the first channel patterns 108 may respectively decrease in a third direction D3 away from or with distance from the lower surface 106L of the substrate 106 (e.g., L_{108-L1} > L_{108-M1} > L_{108-U1}), as indicated by the first dashed lines L1 in FIG. 1A. Accordingly, the edges of the first channel patterns 108 may collectively define a sloped plane relative to the first direction D1.

In some embodiments, a length in the first direction D1 of each of the second channel patterns 110 may be different. As an example, the second channel patterns 110 may include a lower second channel pattern 110-L2, an upper second channel pattern 110-U2, and a middle second channel pattern 110-M2 between the lower and upper second channel patterns 110-L2 and 110-U2. Each of the lower second channel pattern 110-L2, the middle second channel pattern 110-M2, and the upper second channel pattern 110-U2 may have a different length in the first direction D1. As shown in FIG. 1B, the lower second channel pattern 110-L2 has a length L_{110-L2} in the first direction D1, the middle second channel pattern 110-M2 has a length L_{110-M2} in the first direction D1 that is shorter or less than the length L_{110-L2}, and the upper second channel pattern 110-U2 has a length L_{110-U2} in the first direction D1 that is shorter or less than the length L_{110-M2}. That is, the lengths in the first direction D1 of the second channel patterns 110 may respectively decrease in the third direction D3 away from or with distance from the lower surface 106L of the substrate 106 (e.g., L_{110-L2} > L_{110-M2} > L_{110-U2}), as indicated by dashed lines L1 in FIG. 1A. Accordingly, the edges of the second channel patterns 110 may collectively define a sloped plane relative to the first direction D1.

In some embodiments, at least one of the lengths in the first direction D1 of the first channel patterns 108 and at least one of the lengths of the second channel patterns 110 are different from each other. As an example, the lengths of at least one of the second channel patterns L_{110-L2}, L_{110-M2}, L_{110-U2}, is shorter or less than the lengths of at least one of the first channel patterns L_{108-L1}, L_{108-M1}, L_{108-U1} by about at least 10%, such as by about 20-30%. As a more specific example, the lengths of each of the second channel patterns 110 L_{110-L2}, L_{110-M2}, L₁₁₀-_{U2}, is shorter or less than the lengths of each of the first channel patterns 108 L_{108-L1}, L_{108-M1}, L_{108-U1} by about by about 20-30%. In some embodiments, a length of the uppermost first channel pattern among the first channel patterns 108 (e.g., upper first channel pattern 108-U1) may be longer or greater than a length of a lowermost second channel pattern among the second channel patterns 110 (e.g., lower second channel pattern 110-L2).

In some embodiments, a length in the first direction D1 of each of the inner spacers 112 at opposing ends of the conductive gate patterns 107 of the first transistor 102 and/or the second transistor 104 may be the same (or substantially the same).

In some embodiments, a length in the first direction D1 between outer edges of inner spacers 112 provided at respective ends of the conductive gate patterns 107 (e.g., a total length in the first direction D1 of the gate pattern 107 and the inner spacers 112 on each opposing end) of the first and/or second transistors 102, 104 may be different. As an example, the inner spacers 112 between the first channel patterns 108 of the first transistor 102 may include lower first inner spacers 112-L1, upper first inner spacers 112-U1, and middle first inner spacers 112-M1 between the lower and upper first inner spacers 112-L1 and 112-U1, and the inner spacers 112 between the second channel patterns 110 of the second transistor 104 may include lower second inner spacers 112-L2, upper second inner spacers 112-U2, and middle second inner spacers 112-M2 between the lower and upper second inner spacers 112-L2 and 112-U2.

Each of the lower inner spacers 112-L1, 112-M1, 112-U1 may have a different length (L_{112-L1}, L₁₁₂-_{M1}, L_{112-U1}, respectively) in the first direction D1, and/or each of the upper inner spacers 112-L2, 112-M2, 112-U2 may have a different length (L_{112-L2}, L_{112-M2}, L_{112-U2}, respectively) in the first direction D1. Each of the lengths of the upper inner spacers 112-L2, 112-M2, 112-U2 may be less or shorter than each of the lengths of the lower inner spacers 112-L1, 112-M1, 112-U1. In some embodiments, the lengths in the first direction D1 of the inner spacers 112 may respectively decrease in the third direction D3 away from or with distance from the lower surface 106L of the substrate 106 (e.g., L_{112-L1} > L_{112-M1} > L_{112-U1} > L_{112-L2} > L_{112-M2} > L_{112-U2}). In some embodiments, a length of the uppermost inner spacer among the lower inner spacers (e.g., lower inner spacer 112-U1) may be longer or greater than a length of a lowermost inner spacer among the upper inner spacer (e.g., upper inner spacer 112-L2).

In some embodiments, a length in the first direction D1 of the conductive gate patterns 107 of the first and/or second transistors 102, 104 may be different. As an example, the conductive gate patterns 107 of the first transistor 102 may include lower first gate patterns 107-L1, upper first gate patterns 107-U1, and middle first gate patterns 107-M1 between the lower and upper first gate patterns 107-L1 and 107-U1. The gate patterns 107 of the second transistor 104 may include lower second gate patterns 107-L2, upper second gate patterns 107-U2, and middle second gate patterns 107-M2 between the lower and upper second gate patterns 107-L2 and 107-U2.

Each of the lower gate patterns 107-L1, 107-M1, 107-U1 may have a different length (L_{107-L1}, L_{107-M1}, L_{107-U1}, respectively) in the first direction D1, and/or each of the upper gate patterns 107-L2, 107-M2, 107-U2 may have a different length (L_{107-L2}, L_{107-M2}, L_{107-U2}, respectively) in the first direction D1. In some embodiments, the lengths of each of the upper gate patterns 107-L2, 107-M2, 107-U2 are less or shorter than the lengths of each of the lower gate patterns 107-L1, 107-M1, 107-U1. In some embodiments, the lengths in the first direction D1 of the gate patterns 107 may respectively decrease in the third direction D3 away from or with distance from the lower surface 106L of the substrate 106 (e.g., L_{107-L1} > L_{107-M1} > L_{107-U1} > L_{107-L2} > L_{107-M2} > L_{107-U2}), as indicated by the second dashed lines L2 in FIG. 1A. In some embodiments, a length of the uppermost gate pattern among the lower gate patterns (e.g., lower gate pattern 107-U1) may be longer or greater than a length of a lowermost gate pattern among the upper gate patterns (e.g., upper gate pattern 107-L2).

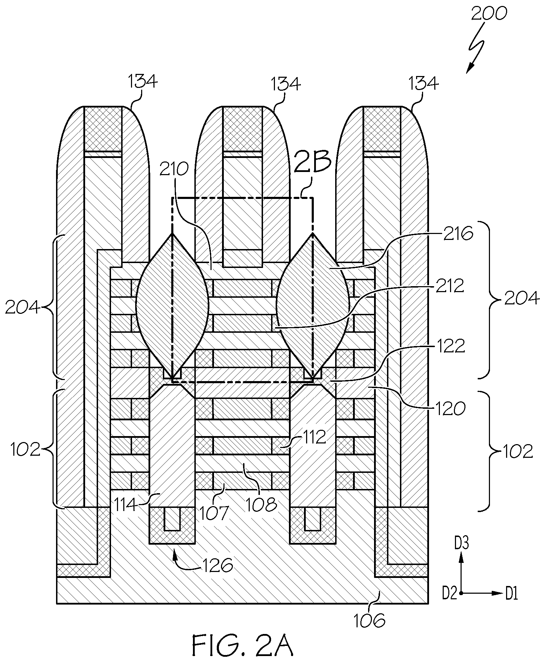

Referring to FIGS. 2A-2B (where FIG. 2B is an enlarged view of region 2B in FIG. 2A), a cross-sectional view illustrating an example configuration of a semiconductor integrated circuit device 200 according to some embodiments of the present disclosure are shown. The semiconductor integrated circuit device 200 is similar to the semiconductor integrated circuit device 100 illustrated in FIGS. 1A-1B except that it includes second transistors 204 instead of the second transistors 104. That is, the second transistor 204 includes second source/drain regions 216 that have a curved or nonlinear profile (e.g., a circular and/or elliptical shape) that is convex toward second channel patterns 210 and inner spacers 212, such that a width of the second source/drain regions 216 (in the first direction D1) varies among the second channel patterns 210 in the direction in which the second channel patterns 210 are stacked. In some embodiments, the second channel patterns 210 may include a lower second channel pattern 210-L2, a middle second channel pattern 210-M2, and an upper second channel pattern 210-U2, and the inner spacers 212 may include lower second inner spacers 212-L2, middle second inner spacers 212-M2, and upper second inner spacers 212-U2. While three second channel patterns 210 and pairs of inner spacers 212 are shown, it should be understood that any number of second channel patterns 210 and pairs of inner spacers 212 may be included and is not limited to the examples described herein. Furthermore, it should be understood that the characteristics described with reference to the second transistor 204 may be alternatively or additionally applied to the first transistor 102 in other embodiments. For example, while illustrated in FIGS. 2A-2B with reference to the upper transistor 204 having the second source/drain regions 216, inner spacers 212, and channel patterns 210 with curved or nonlinear side surfaces, it will be understood that these characteristics may be additionally or alternatively applied to the source/drain regions 114, inner spacers 112, and channel patterns 108 of the lower transistor 102 in some embodiments.

In some embodiments, as shown in FIG. 2B, the lower second channel pattern 210-L2 has a length L₂₁₀₋₁₂ in the first direction D1, the middle second channel pattern 210-M2 has a length L_{210-M2} in the first direction D1 that is less or shorter than the length L_{210-L2} of the lower second channel pattern 210-L2, and the upper second channel pattern 210-U2 has a length L_{210-M2} in the first direction D1 that is greater or longer than the length L_{210-M2} (e.g., the middle second channel pattern length L_{210-M2} is less or shorter than the lengths of each of the second channel patterns thereabove and therebelow in a third direction D3).

In some embodiments, a length L_{212-M2} of the middle second inner spacer 212-M2 may be less or shorter than a length L_{212-L2}, L_{212-U2} of each of the lower and upper second inner spacers 212-L2 and 212-U2, and the length L_{212-U2} of the middle second inner spacer 212-M2 may be less than a length of each of the inner spacers 112 of the first transistor 102 (e.g., the length L_{212-U2} of the middle second inner spacer(s) 212-M2 is shorter or less than the lengths of each of the second inner spacer patterns 212 thereabove and therebelow in the third direction D2, and is shorter or less than the lengths of each of the first inner spacers 112 of the first transistor 102). That is, the length L_{212-M2} of the middle second inner spacer(s) 212-M2 may be the shortest among the respective lengths of the other second inner spacers 212-L2, 212-U2 and the inner spacers 112. The respective lengths of the lower, middle, and upper gate patterns 107-L2, 107-M2, 107-U2 of the second transistor 204 may be substantially uniform between the lower, middle, and upper second inner spacers 212-L2, M2, 212-U2 in the embodiment of FIG. 2B.

In some embodiments, the second inner spacers 212-L2, 212-M2, 212-U2 of the second transistor 204 (and/or the inner spacers 112 of the first transistor 102) may be omitted, as shown in FIG. 2C (which is an alternative enlarged view of region 2B in FIG. 2A). Accordingly, and referring to FIG. 2C, the conductive gate patterns 107 of the second transistor 204 may be replaced with conductive gate patterns 207 that directly contact the second source/drain regions 216. The conductive gate patterns 207 may include a lower second gate pattern 207-L2 with a length L_{207-L2} in the first direction D1, a middle second gate pattern 207-M2 with a length L_{207-M2} in the first direction D1 that is less or shorter than the length L_{207-L2} of the lower second gate pattern 207-L2, and an upper second gate pattern 207-U2 that has a length L_{207-M2} in the first direction D1 that is greater or longer than the length L_{207-M2} than the middle second gate pattern 207-M2. A length L_{207-L2}, L_{207-M2} in the first direction D1 of each of the lower and upper second gate patterns 207-L2 and 207-U2 may be greater or longer than a length L_{207-M2} in the first direction D1 of the middle second gate pattern 207-M2.

As noted, the characteristics described with reference to the second transistor 204 may be alternatively or additionally applied to the first transistor 102 in other embodiments. That is, while illustrated in FIG. 2C with reference to the upper transistor 204 having the second source/drain regions 216, the second channel patterns 210, and the second gate patterns 207 with curved or nonlinear side surfaces, it will be understood that these characteristics may be additionally or alternatively applied to the first source/drain regions 114, the first channel patterns 108, and the gate patterns 107 of the lower transistor 102 in some embodiments. For example, when the channel patterns 108, 210 are implemented as nanosheets, the inner spacers 112 may be between adjacent ones of the lower nanosheets 108, and the upper nanosheets 210 may be free of inner spacers therebetween; or the inner spacers 212 may be between adjacent ones of the upper nanosheets 210, and the lower nanosheets 108 may be free of inner spacers therebetween; or both the upper nanosheets 210 and the lower nanosheets 108 may be free of inner spacers therebetween.

A method of forming the semiconductor integrated circuit device 100 illustrated in FIGS. 1A-1B is described below with reference to FIGS. 3A-3F, which illustrate schematic cross-sectional views depicting intermediate processes of forming the semiconductor integrated circuit device 100. It should be understood that certain steps may not be performed in various embodiments, and the order of the steps for forming the semiconductor integrated circuit device 100 are not limited to the examples illustrated and described herein.

Referring to FIG. 3A, the method of forming the semiconductor integrated circuit device 100 may include forming a plurality of channel layers 302 and sacrificial layers 304 that are alternatingly stacked on the substrate 106. In some embodiments, the method may further include forming a middle sacrificial layer 306 that is between a pair of the sacrificial layers 304 (which may correspond to the first and second transistors 102 and 104). The middle sacrificial layer 306 may have a greater thickness than the sacrificial layers 304 in some embodiments. The plurality of channel layers 302 may include semiconductor materials, such as silicon (Si), and the sacrificial layers 304, 306 may include materials having etching selectivity with the materials of the channel layers 302, such as silicon germanium (SiGe).

Referring to FIGS. 3B-3D, the method of forming the semiconductor integrated circuit device 100 may include forming the channel patterns of the first transistors 102 and/or the second transistors 104 (e.g., the first and second channel patterns 108 and 110) with respective lengths that differ (e.g., at least one of the channel patterns of the second transistor 104 is shorter than that of at least one of the channel patterns of the first transistor 102 by about 10 percent or more) and sacrificial gate patterns 308 (or inner spacers 112) of the first and/or second transistors 102, 104 with respective lengths that differ.

To form the channel patterns 108, 110 and the sacrificial gate patterns 308, for example, and with reference to FIG. 3B, the method may include performing a tapered etching process on the channel layers 302, the sacrificial layers 304, the middle sacrificial layer 306, and a portion of the substrate 106 to form recesses 310 that extend into at least a portion of the substrate 106 at opposing sides of the channel layers 302, the sacrificial layers 304, and the middle sacrificial layer 306. The tapered etching process may include a wet etching process and/or a dry etching process (such as plasma-enhanced etching) and one or more mask patterns such that resulting edges of the channel layers 302, the sacrificial layers 304, and the middle sacrificial layer 306 are sloped relative to the third direction D3 (e.g., the vertical direction). The tapered etching process may involve gases including, but not limited to, HBr, Cl₂, O₂, SF6, and N₂. In some embodiments, the tapered etching process includes performing a dry etching process and controlling parameters thereof to form the desired slope (e.g., controlling mass flow, pressure, power, ion density, and etchant ratios). In some embodiments, the tapered etching process includes performing a wet etching process and controlling parameters thereof to form the desired slope (e.g., controlling the etchant types). In some embodiments, the tapered etching process includes utilizing a mask pattern having edges that have a slope to thereby form the sloped surface of the contact recesses 310 using the dry or wet etching processes.

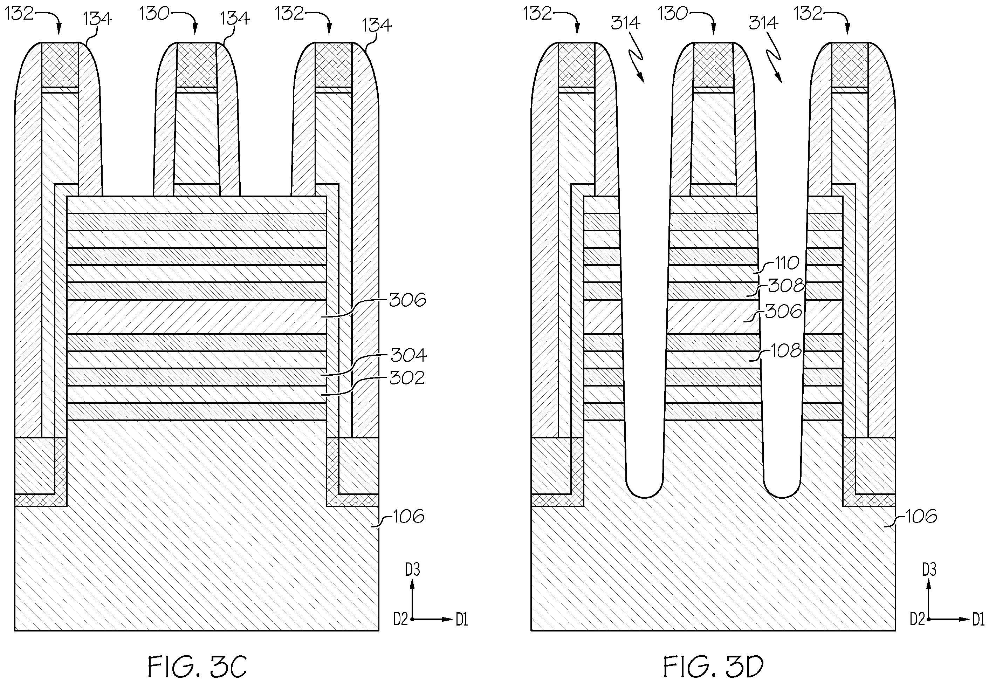

Referring to FIG. 3C, the method of forming the semiconductor integrated circuit device 100 may further include forming mask structures 130, 132 (which may include one or more capping patterns or other protective patterns) and spacer structures 134 in the recesses 310 and on a portion of the remaining alternating stack. In FIG. 3D, the method may include performing a tapered etching process using the mask structures 130, 132, and spacer structures 134 as an etching mask to form recesses 314 that define the first and second channel patterns 108, 110 from the channel layers 302, and the sacrificial gate patterns 308 from the sacrificial layers 304.

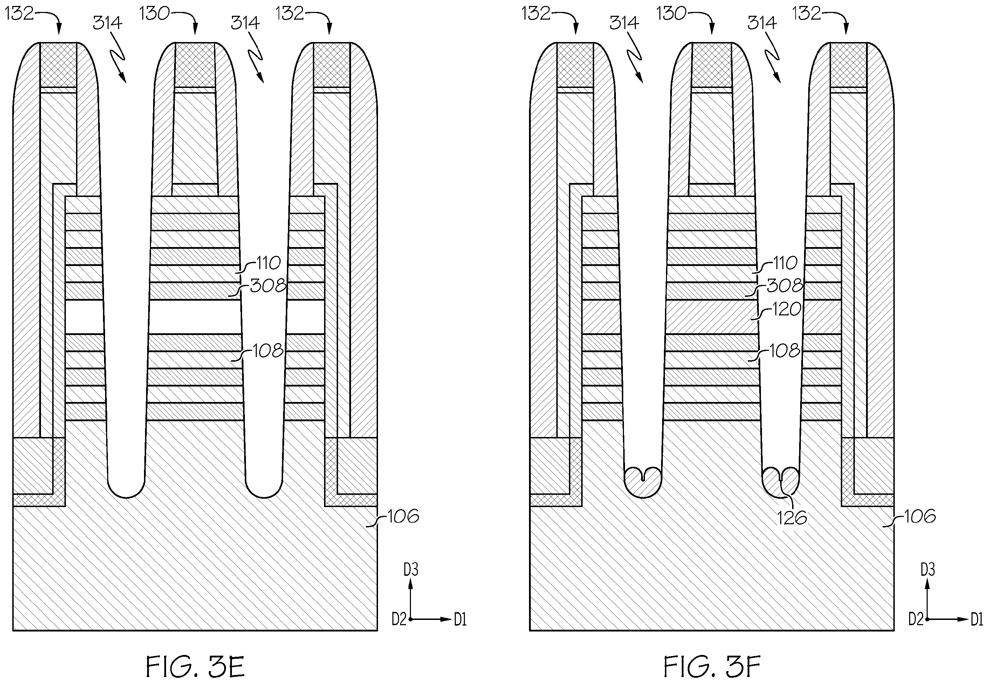

Referring to FIG. 3E, a selective etching process is performed to remove the middle sacrificial layer 306. As shown in FIG. 3F, an isolation pattern 120 (also referred to as a middle dielectric isolation (MDI)) is formed by filling the region from which the middle sacrificial layer 306 was removed with an insulating material, such as (but not limited to) SiN, SiOx, SiBCN, SiCN, SiON, SiOCN, or other insulating material. For example, the recesses 314 and the region from which the middle sacrificial layer 306 was removed may be filled with the MDI insulating material, which may be substantially removed from the recesses 314 to form the isolation pattern 120. Portions of the insulating material may remain at the bottom of the recesses 314 to form preliminary insulating regions 126'.

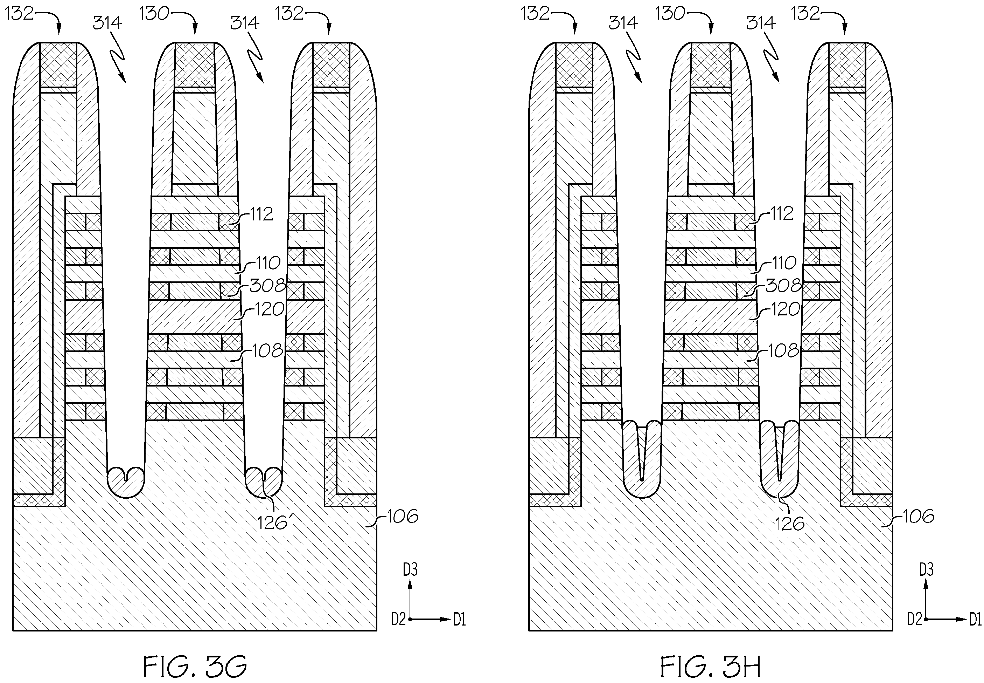

Referring to FIG. 3G, edges of the sacrificial gate patterns 308 are selectively recessed, and inner spacers 112 are formed at opposing ends thereof. The inner spacers 112 may be formed of a low-k material (e.g., an oxide or a nitride, such as but not limited to SiN, SiOx, SiBCN, SiCN, SiON, SiOCN) or other insulating material. For example, a selective etch process may be used to recess the edges or side surfaces of the sacrificial gate patterns 308 that are exposed by the recesses 314, and an oxide or nitride layer may be formed on the recessed ends of the sacrificial gate patterns 308 to form the inner spacers 112. In some embodiments, the selective etch process may recess the edges or side surfaces of the sacrificial gate patterns 308 by a substantially similar amount, such that two or more of the inner spacers 112 may have substantially similar lengths in the first direction D1 (e.g., such that L_{112-L1}, L_{112-M1}, L_{112-U1}, L_{112-L2}, L_{112-M2}, and/or L_{112-M2} in FIG. 1B are substantially equal). In other embodiments, the selective etch process may recess the edges or side surfaces of the sacrificial gate patterns 308 by different amounts, such that two or more of the inner spacers 112 may have different lengths in the first direction D1 (e.g., such that L_{112-L1} > L_{112-M1} > L_{112-U1}, and/or L_{112-L2}> L_{112-M2} > L_{112-U2}). The recessed sacrificial gate patterns 308 may have different lengths in the first direction D1 responsive to the selective etch process used to form the inner spacers 112.

The recesses 314 may extend into portions of the substrate 106 such that the substrate 106 may include recessed surfaces adjacent the opposing sides of the first channel patterns 108. As shown in FIG. 3H, one or more insulating patterns may be formed in or on the portions of the substrate 106 to at least partially fill the recessed surfaces, forming insulating regions 126. In some embodiments, the insulating regions 126 may be oxide-based (e.g., silicon oxide) patterns or nitride-based (e.g., silicon nitride) patterns, which may be formed by filling the recesses 314 with the oxide or nitride -based material, and etching the material to provide the insulating regions 126.

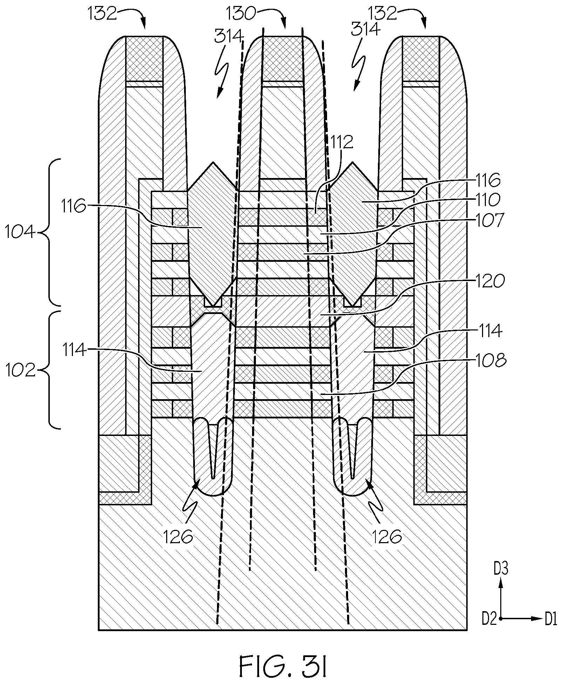

Referring to FIG. 3I, the method of forming the semiconductor integrated circuit device 100 may include forming the first source/drain regions 114 at opposing ends of the first channel patterns 108 and in the recesses 314. For example, the first source/drain regions 114 may be formed by selective epitaxial growth at the opposing sides of the first channel patterns 108. In some embodiments, the first source/drain regions 114 may include a first semiconductor material that is the same as that of the first channel patterns 108. For example, the first channel patterns 108 and the first source/drain regions 114 may be silicon (Si). After growing the first source/drain regions 114, the method includes forming the second isolation patterns 122 on the first source/drain regions 114. For example, an oxidation process (e.g., plasma oxidation or thermal oxidation) may be performed to oxidize upper surfaces of the first source/drain regions 114 to form the second isolation patterns 122. The method further includes forming the second source/drain regions 116 at opposing ends of the second channel patterns 110 and on the second isolation pattern 122, such that the second isolation pattern 122 electrically separates the second source/drain regions 116 from the first source/drain regions 114. For example, the second source/drain regions 116 may be formed by selective epitaxial growth at the opposing sides of the second channel patterns 110. In some embodiments, the second source/drain regions 122 may include a second semiconductor material that is different from a first semiconductor material of the second channel patterns 110. For example, the second channel patterns 110 may be silicon (Si), while the second source/drain regions 116 may be silicon germanium (SiGe). It will be understood that the first and second source/drain regions 114 and 116 may be formed in any order, and are not limited to the order described above.

Additionally, still referring to FIG. 3I, the method may further include replacing the sacrificial gate patterns 308 with the conductive gate patterns 107 between first and second source/drain regions 114, 116 (or between inner spacers 112) to thereby form the first and second transistors 102, 104 of the integrated circuit device 100 shown in FIGS. 1A-1B.

As shown in FIG. 1B, due to the tapered etching process(es) described above with reference to FIGS. 3B and/or 3D, the respective lengths L_{110-L2}, L₁₁₀-_{M2}, L_{110-U2} of the second (upper) channel patterns 110 are less than or shorter than the respective lengths L_{108-L1,} L_{108-M1}, L_{108-U1} of the first (lower) channel patterns 108, such that the second (upper) source/drain regions 116 formed at the opposing ends of the second channel patterns 110 may be wider (in the first direction D1) than the first (lower) source/drain regions 114 formed at opposing ends of the first channel patterns 108. For example, the second source/drain regions 116 may wider than the first source/drain regions 114 by about at least 10%, such as by about 20-30%, in some embodiments.

Also, while illustrated in FIGS. 1A-1B and 3A-3F with reference to forming both the first and second transistors 102, 104 of the integrated circuit device 100 using the tapered etching process(es) described above with reference to FIGS. 3B and 3D, it will be understood that embodiments of the present disclosure are not so limited. For example, in some embodiments, a tapered etch process may be used to form the first transistor 102 (such that respective lengths of the channel patterns 108, the gate patterns 107, and/or the inner spacers 112 thereof differ along the first direction D1), while the respective lengths of the channel patterns 110, the gate patterns 107, and/or the inner spacers 112 of the second transistor 104 are substantially equal (e.g., formed using anisotropic etching processes, as described in further embodiments below), or vice versa. More generally, the operations shown in FIGS. 3A-3F may be varied to independently control the respective lengths of the channel patterns 108/110, the gate patterns 107, and/or the inner spacers 112 of the first and/or second transistors 102/104 in various combinations.

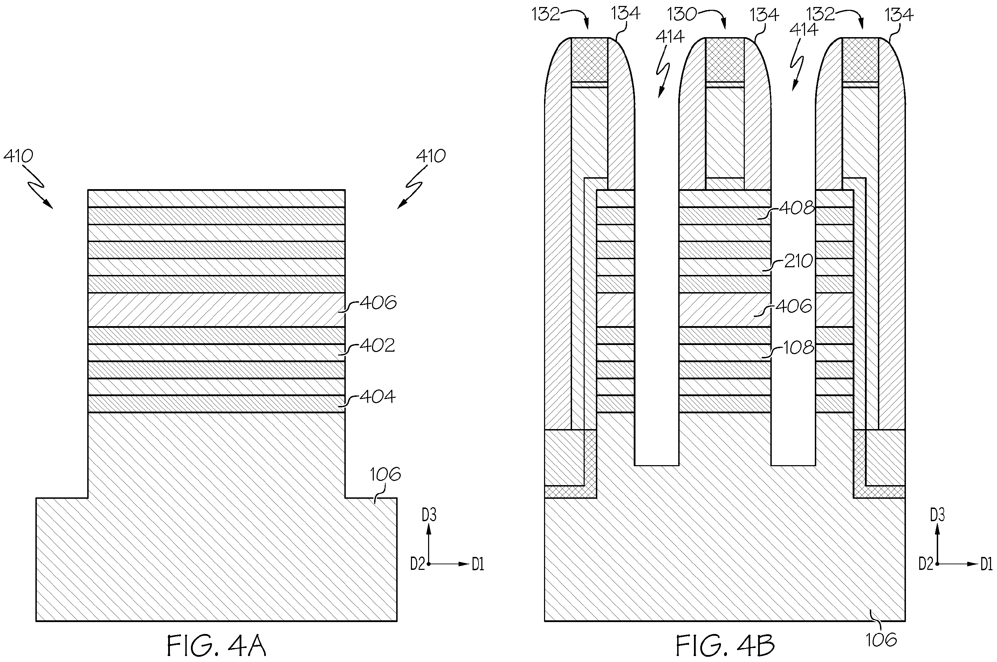

A method of forming the semiconductor integrated circuit device 200 illustrated in FIGS. 2A-2C is described below with reference to FIGS. 4A-4F, which illustrate schematic cross-sectional views depicting intermediate processes of forming the semiconductor integrated circuit device 200. It should be understood that certain steps may not be performed in various embodiments, and the order of the steps for forming the semiconductor integrated circuit device 200 are not limited to the examples illustrated and described herein.

Referring to FIG. 4A, the method of forming the semiconductor integrated circuit device 200 may include forming the plurality of channel layers 402 and sacrificial layers 404 that are alternatingly stacked on the substrate 106 and a middle sacrificial layer 406 interposed between a pair of the sacrificial layers 404 in a similar manner described above with reference to forming the channel layers 302, the sacrificial layers 304, and the middle sacrificial layer 306 in FIG. 3A.

With continued reference to FIG. 4A, the method may include etching (e.g., wet or dry etching) the channel layers 402, the sacrificial layers 404, the middle sacrificial layer 406, and a portion of the substrate 106 to form recesses 410 that extend into at least a portion of the substrate 106at opposing sides of the channel layers 402, the sacrificial layers 404, and the middle sacrificial layer 406. In some embodiments, the channel layers 402 that vertically overlap each other (e.g., in the third direction D3) may have a substantially same length in the first direction D1 (unlike the embodiments illustrated in FIG. 3B), and the sacrificial layers 404 that vertically overlap each other may have a substantially same length in the first direction D1 (unlike the embodiments illustrated in FIG. 3B). That is, the etching of the channel layers 402, the sacrificial layers 404, the middle sacrificial layer 406 illustrated in FIG. 4B may be anisotropic, and may not form the tapered slope described above with reference to FIG. 3B.

Referring to FIG. 4B, the method may include forming mask structures 130, 132 (which may include one or more capping patterns or other protective patterns) and spacer structures 134 in the recesses 410 and on a portion of the remaining alternating stack, and performing an etching process (e.g., an anisotropic etching process similar to that described above with reference to FIG. 4A) to form the first and second channel patterns 108, 210 from the channel layers 402, the sacrificial gate patterns 408 from the sacrificial layers 404, and recesses 414. In some embodiments, the channel patterns 108, 210, the first isolation patterns 120, and the sacrificial gate patterns 408 may have substantially the same length in the first direction D1, responsive to the etching process. The recesses 414 may extend into a portion of the substrate 106 to provide recessed surfaces adjacent the opposing sides of the channel patterns 108, 210 and the sacrificial gate patterns 408. An isolation pattern 120 (or MDI) is formed by selectively removing the middle sacrificial layer 406, and filling the region from which the middle sacrificial layer 406 was removed with an insulating material, as similarly described above with reference to FIGS. 3E and 3F.

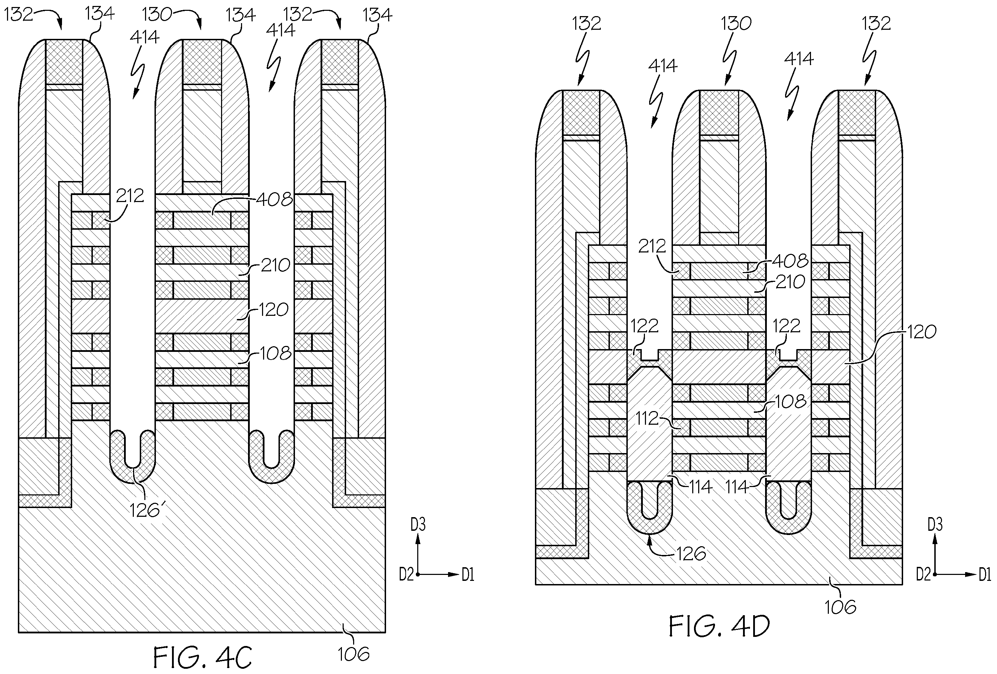

Referring to FIG. 4C, in some embodiments, edges of the sacrificial gate patterns 408 are selectively recessed, and inner spacers 212 are formed at opposing ends thereof. For example, a selective etch process may be used to recess the edges or side surfaces of the sacrificial gate patterns 408 that are exposed by the recesses 414, and an oxide or nitride layer (such as but not limited to SiN, SiOx, SiBCN, SiCN, SiON, SiOCN) may be formed on the recessed ends of the sacrificial gate patterns 408 to form the inner spacers 212. In some embodiments, the selective etch process may recess the edges or side surfaces of the sacrificial gate patterns 308 by a substantially similar amount, such that two or more of the inner spacers 212 may have substantially similar lengths in the first direction D1 (e.g., such that L_{212-L1}, L_{212-M1}, L_{212-U1}, L_{212-L2}, L_{212-M2}, and/or L_{212-U2} in FIG. 2B are substantially equal). In other embodiments, the selective recessing process and the formation of the inner spacers 212 may be omitted (e.g., as shown in FIG. 2C).

Referring to FIG. 4D, one or more insulating patterns may be formed in or on the portions of the substrate 106 to at least partially fill the recessed surfaces, forming insulating regions 126 (as similarly discussed above with reference to FIG. 3H), and first source/drain regions 114 may be formed at opposing ends of the first channel patterns 108 to thereby form the first transistor 102 of FIG. 2A. The insulating regions 126, the first source/drain regions 114, and the second isolation pattern 122 may be formed in a similar manner as described above with reference to FIG. 3F. For example, the first source/drain regions 114 may be formed by selective epitaxial growth at the opposing sides of the first channel patterns 108, in some embodiments of a same semiconductor material as that of the first channel patterns 108 (e.g., Si). After growing the first source/drain regions 114, the method includes forming second isolation patterns 122 on the first source/drain regions 114 (e.g., by plasma oxidation or thermal oxidation of upper surfaces of the first source/drain regions 114).

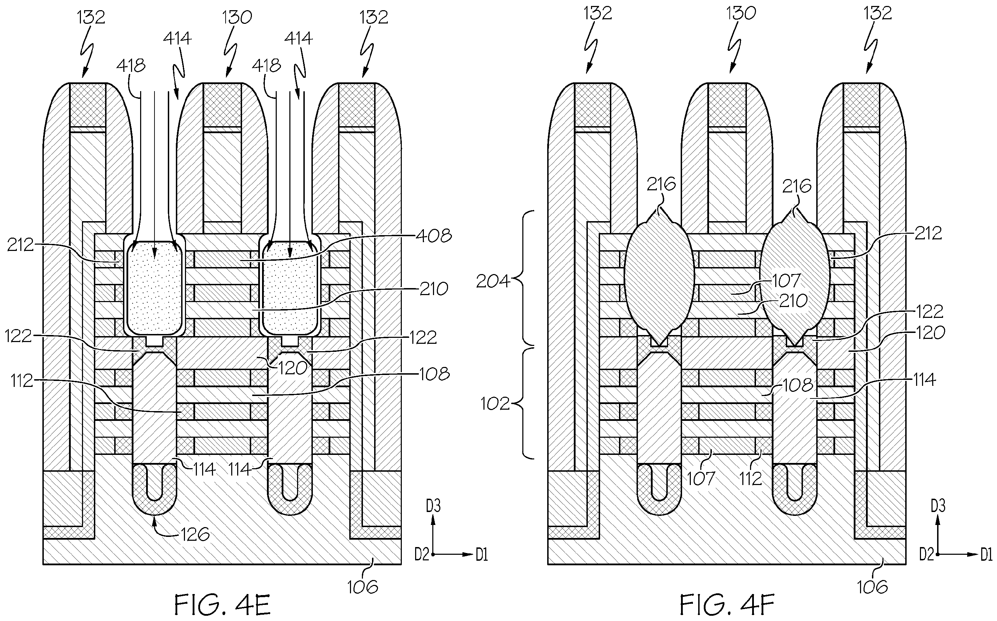

Referring to FIG. 4E, the method includes performing one or more bowl etching processes 418 such that side surfaces of the channel patterns 210, sacrificial gate patterns 408, and/or inner spacers 212 that are exposed by the recess 414 have a curved or nonlinear profile that is convex toward the second channel patterns 210. The bowl etching process 418 (e.g., a dry or wet etching process) is configured to remove portions of the channel patterns 210 and the sacrificial gate patterns 408 (and/or the inner spacers 212) that are positioned in a middle of the stack to a greater extent (i.e., such that the middle patterns are shorter) relative to the respective layers/patterns thereabove and therebelow in the stack. The bowl etching process 418 may involve gases including, but not limited to, HBr, Cl₂, O₂, SF6, and N₂. In some embodiments, the bowl etching process 418 may include performing a dry etching process (such as plasma-enhanced etching) and controlling parameters thereof to form the curved or non-linear profiles (e.g., controlling mass flow, pressure, power, ion density, and etchant ratios). In some embodiments, the bowl etching process 418 may include performing a wet etching process and controlling parameters thereof to form the curved or non-linear profiles (e.g., controlling the etchant types). The second isolation patterns 122 and the first isolation pattern 120 may collectively function as an etch stop layer, thereby protecting the underlying first source/drain regions 114, channel patterns 108, sacrificial gate patterns 408, and/or inner spacers 112 from being etched by the bowl etching process 418.

Referring to FIG. 4F, the method includes forming the second source/drain regions 216 of the second transistor 204 at opposing ends of the second channel patterns 210, as shown in FIG. 2A. The second source/drain regions 216 may be formed in a similar manner as described above with reference to FIG. 3F. For example, the second source/drain regions 116 may be formed by selective epitaxial growth at the opposing sides of the second channel patterns 210, in some embodiments of a semiconductor material (e.g., SiGe) that is different from that of the second channel patterns 210 (e.g., Si).

Additionally, and with reference to FIG. 4F, the method may further include replacing the sacrificial gate patterns 408 with the conductive gate patterns 107 or 207 between first and second source/drain regions 114, 216 (or between inner spacers 112, 212) to thereby form the first and second transistors 102, 204 of the integrated circuit device 200 of FIGS. 2A-2C. As shown in FIG. 2B, due to the bowl etching process(es) 418 described above with reference to FIG. 4E, respective lengths L_{210-M2} and L_{212-M2} of the middle channel patterns 210_M2 and inner spacers 212_M2 in the first direction D1 may be less than or shorter than respective lengths L_{210-L2} and L_{210-M2} of the channel patterns 210_L2, 210_U2 and respective lengths L_{212-L2} and L_{212-U2} of the inner spacers 212_L2, 212_U2 therebelow and thereabove. Alternatively, in embodiments where the inner spacers 212 are omitted as shown in FIG. 2C, due to the bowl etching process(es) 418 described above with reference to FIG. 4E, respective lengths L_{210-M2} and L_{207-M2} of the middle channel patterns 210_M2 and gate patterns 207_M2 may be less than or shorter than respective lengths L_{210-L2} and L_{210-M2} of the channel patterns 210_L2, 210_U2 and respective lengths L_{207-L2} and L_{207-M2} of the gate patterns 207_L2, 207_U2 therebelow and thereabove. More generally, it will be understood that the operations shown in FIGS. 4A-4F may be varied to independently control the respective lengths of the channel patterns 108/210, the gate patterns 107/207, and/or the inner spacers 112 of the first and/or second transistors 102/204 in various combinations.

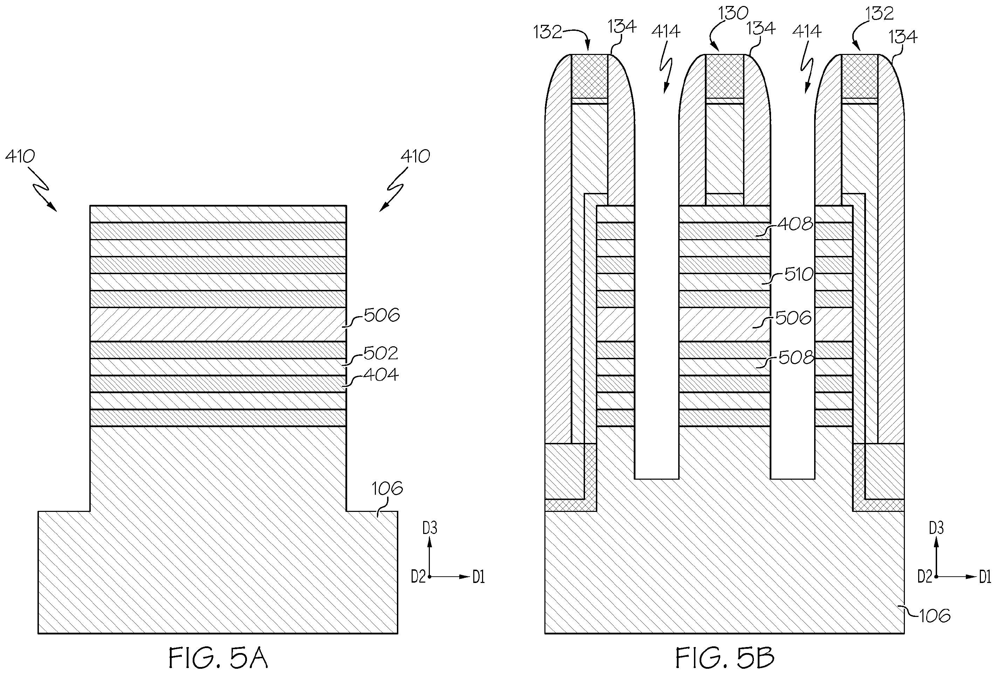

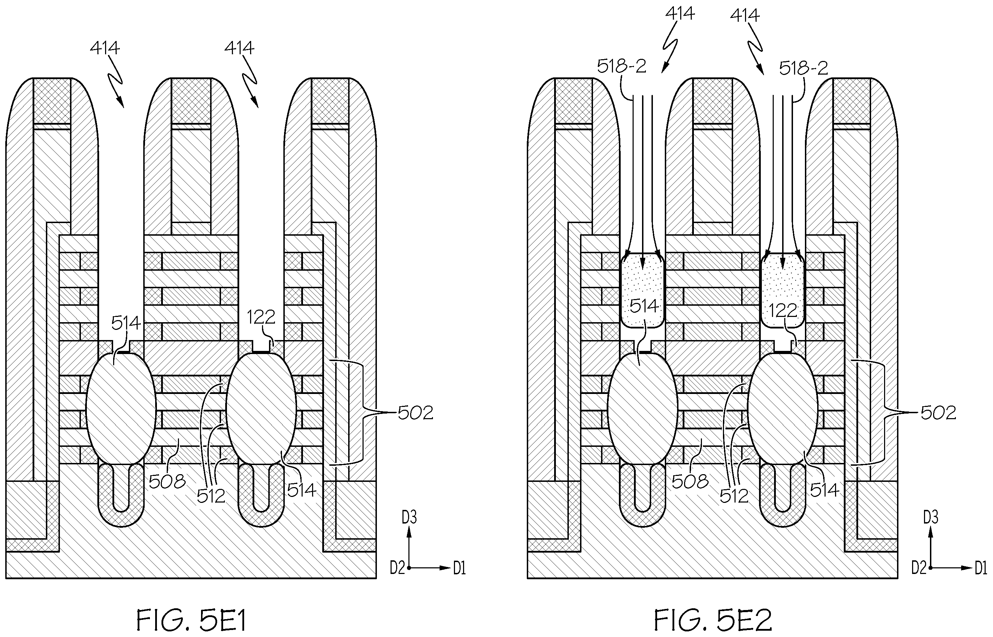

Another method of forming a semiconductor integrated circuit device is described below with reference to FIGS. 5A-5D, 5E1/5E2, and 5F1/5F2, which illustrate schematic cross-sectional views depicting intermediate processes of forming a semiconductor integrated circuit device 500, 500'. It should be understood that certain steps may not be performed in various embodiments, and the order of the steps for forming the semiconductor integrated circuit device are not limited to the examples illustrated and described herein.

The method illustrated in FIGS. 5A-5D, 5E1, and 5F1 to form integrated circuit device 500 is similar to the method illustrated in FIGS. 4A-4F, except that the bowl etching process is performed before the second isolation pattern 122 (e.g., an etch stop layer) and the second source/drain regions are formed. The method illustrated in FIGS. 5A-5D, 5E2, and 5F2 to form integrated circuit device 500' is similar to the method illustrated in FIGS. 4A-4F and FIGS. 5A-5D, 5E1, and 5F1, except that a first bowl etching process 518-1 is performed before the first or lower source/drain regions 514 and second isolation pattern 122 are formed, and a second bowl etching process 518-2 is performed after the second isolation pattern 122 is formed and before the second or upper source/drain regions 516 are formed.

Referring to FIG. 5A, the method of forming the semiconductor integrated circuit device 500, 500' may include forming the plurality of channel layers 501 and sacrificial layers 404 that are alternatingly stacked on the substrate 106 and an middle sacrificial layer 506 interposed between a pair of the sacrificial layers 404 in a similar manner described above with reference to forming the channel layers 302/402, the sacrificial layers 304/404, and the middle sacrificial layer 306/406 in FIGS. 3A and 4A.

With continued reference to FIGS. 5A, the method may include etching (e.g., wet or dry etching) the channel layers 501, the sacrificial layers 404, the middle sacrificial layer 506, and a portion of the substrate 106 to form recesses 530 that extend into at least a portion of the substrate 106 at opposing sides of the channel layers 501, the sacrificial layers 404, and the middle sacrificial layer 506. In some embodiments, the channel layers 501 that vertically overlap each other (e.g., in the third direction D3) may have a substantially same length in the first direction D1, and the sacrificial layers 404 that vertically overlap each other may have a substantially same length in the first direction D1.

Referring to FIG. 5B, the method may include forming mask structures 130, 132 (which may include one or more capping patterns or other protective patterns) and spacer structures 134 in the recesses 410 and on a portion of the remaining alternating stack, and performing an etching process (e.g., an anisotropic etching process similar to that described above with reference to FIG. 4B) to form the first and second channel patterns 508, 510 from the channel layers 501, the sacrificial gate patterns 408 from the sacrificial layers 404, and recesses 414, in some embodiments with the channel patterns 508, 510, the first isolation patterns 120, and the sacrificial gate patterns 408 having substantially the same length in the first direction D1. The recesses 414 may extend into a portion of the substrate 106 to provide recessed surfaces adjacent the opposing sides of the channel patterns 508, 510 and the sacrificial gate patterns 408. An isolation pattern 120 (or MDI) is formed by selectively removing the middle sacrificial layer 506, and filling the region from which the middle sacrificial layer 506 was removed with an insulating material, as similarly described above with reference to FIGS. 3E and 3F.

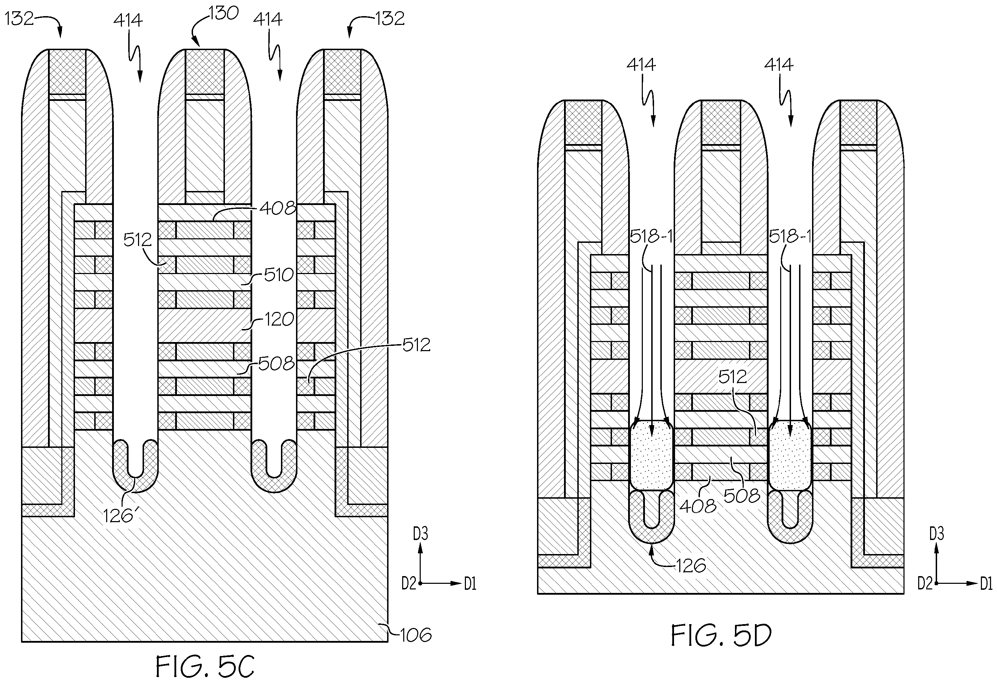

Referring to FIG. 5C, in some embodiments, edges of the sacrificial gate patterns 408 are selectively recessed, and inner spacers 512 are formed at opposing ends thereof, in a manner similar to that described above with reference to forming the inner spacers 212 in FIG. 4C. In other embodiments, the selective recessing process and the formation of the inner spacers 512 may be performed in a subsequent operation.

Referring to FIG. 5D, one or more insulating patterns may be formed in or on the portions of the substrate 106 to at least partially fill the recessed surfaces, forming insulating regions 126 (as similarly discussed above with reference to FIG. 3H), and a bowl etch process 518-1 may be performed such that side surfaces of the channel patterns 508, sacrificial gate patterns 408, and/or inner spacers 512 that are exposed by the recess 414 have a curved or nonlinear profile that is convex toward the first channel patterns 508. The bowl etching process 518-1 may be similar to the bowl etching process 418 described with reference to FIG. 4E, such that middle first channels 508 and inner spacers 512 (or sacrificial gate patterns 408, in embodiments where the spacers 512 are omitted) of the first/lower transistor 502 are formed shorter in the first direction D1 than the channels 508 and inner spacers 512 (or sacrificial gate patterns 408) of the first/lower transistor 502 thereabove and therebelow.

Referring to FIGS. SE1-SF1, the method may include forming first source/drain regions 514 of the first transistor 502 at opposing ends of the first channel patterns 508, forming the second isolation pattern 122 thereon, and forming second source/drain regions 516 of the second transistor 504 on the second isolation pattern 122 and at opposing ends of the second channel patterns 510. The first source/drain regions 514, second isolation pattern 122, and second source/drain regions 516 may be formed in a manner similar to that of the first source/drain regions 114, second isolation pattern 122, and second source/drain regions 216 as described with reference to FIGS. 4D and 4F. Due to performing the bowl etching process 518-1 such that middle first channels 508 and inner spacers 512 (or sacrificial gate patterns 408) of the first/lower transistor 502 are formed shorter in the first direction D1 than the channels 508 and inner spacers 512 (or sacrificial gate patterns 408) thereabove and therebelow, a width of the first source/drain regions 514 (in the first direction D1) varies between the first channel patterns 508, while a width of the second source/drain regions 516 may be substantially uniform between the second channel patterns 510.

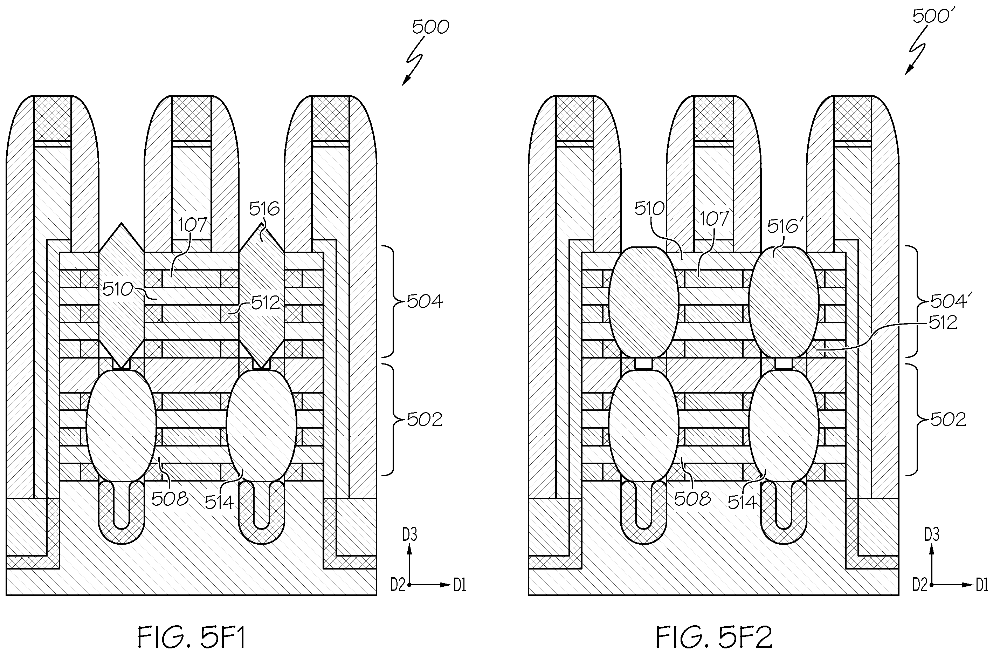

Additionally, and with reference to FIG. 5F1, the method may further include replacing the sacrificial gate patterns 408 with the conductive gate patterns 107 between first and second source/drain regions 514 and 516 (or between inner spacers 512) to thereby form the first and second transistors 502, 504.

In one variation, the processes illustrated in FIGS. 5E2 and 5F2 may be performed instead of those of FIGS. 5E1 and 5F1, to form the first and second transistors 502 and 504'. Referring to FIG. 5E2, after performing the first bowl etching process 518-1 as shown in FIG. 5D, first source/drain regions 514 are formed at opposing ends of the first channel patterns 508, and the second isolation pattern 122 is formed thereon, in a manner similar to that of forming the first source/drain regions 114 and second isolation pattern 122 described with reference to FIG. 4D. A second bowl etching process 518-2 is performed after the second isolation pattern 122 is formed, such that the second isolation pattern 122 and the first isolation pattern 120 function as etch stop layers that protect the underlying layers of the first/lower transistor 502. The second bowl etching process 518-2 may be similar to the bowl etching process 418 described with reference to FIG. 4E, such that middle second channels 510 and inner spacers 512 (or sacrificial gate patterns 408, in embodiments where the spacers 512 are omitted) of the second/upper transistor 504' are formed shorter in the first direction D1 than the channels 510 and inner spacers 512 (or sacrificial gate patterns 408) of the second/upper transistor 504' thereabove and therebelow.

Referring to FIG. 5F2, the method includes forming the second source/drain regions 516' at opposing ends of the second channel patterns 210. The second source/drain regions 516' may be formed in a similar manner as described above with reference to forming the second source/drain regions 216 in FIG. 4F. The method may further include replacing the sacrificial gate patterns 408 with the conductive gate patterns 107 between first and second source/drain regions 514 and 516 (or between inner spacers 512) to thereby form the first and second transistors 502, 504'.

Due to sequentially performing the first and second bowl etching processes 518-1 and 518-2, the middle first channels 508, 510 and inner spacers 512 (or sacrificial gate patterns 408) of each of the first/lower transistor 502 and the second/upper transistor 504' are formed shorter in the first direction D1 than the channels 508, 510 and inner spacers 512 (or sacrificial gate patterns 408) thereabove and therebelow. As such, a width of the first source/drain regions 514 and the second source/drain regions 516' (in the first direction D1) varies between the first channel patterns 508 and the second channel patterns 510, respectively. However, it will be understood that the operations shown in FIGS. 5A-5F2 may be varied to independently control the respective lengths of the channel patterns 508/510, the gate patterns 107, and/or the inner spacers 512 of the first and/or second transistors 502/504 in various combinations.

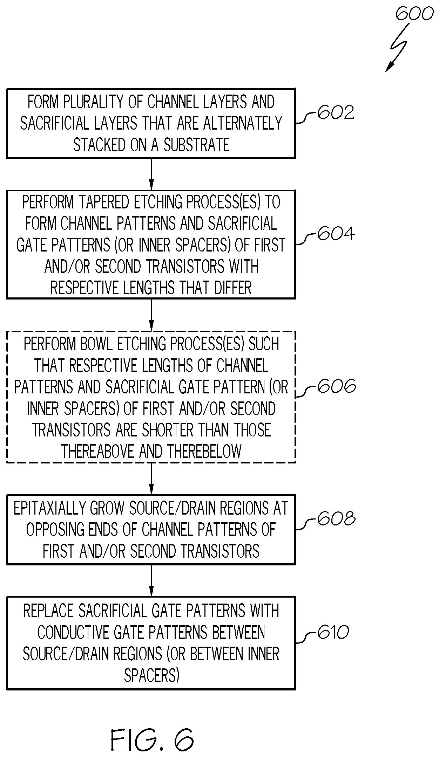

FIG. 6 is a flowchart 600 illustrating a method of forming the integrated circuit device according to some embodiments. The method illustrated in flowchart 600 may correspond to intermediate process diagrams described above either alone or in combination, such as the intermediate process diagrams of FIGS. 3A-3F, or a combination of intermediate process diagrams illustrated by FIGS. 3A-3F, 4A-4F, 5A-5D, 5E1, 5E2, 5F1, and/or 5F2. It should be understood that certain steps may not be performed in various embodiments, and the order of the steps for forming the semiconductor integrated circuit device are not limited to the examples illustrated and described herein.

At step 602, the method may include forming a plurality of channel layers and sacrificial layers that are alternately stacked on a substrate (e.g., the intermediate process illustrated in FIG. 3A). At step 604, the method may include performing one or more tapered etching processes to form channel patterns and sacrificial gate patterns (and optionally, inner spacers at opposing ends thereof) for first and/or second transistors (e.g., lower and upper transistors that are stacked on the substrate) with respective lengths that differ (e.g., the intermediate processes illustrated in FIGS. 3B-3E). At optional step 606, the method may include performing one or more bowl etching processes such that the respective lengths of the middle channel patterns and the middle sacrificial gate patterns (and optionally, the middle inner spacers) of at least one of the first or second transistors are shorter than those thereabove/therebelow (e.g., the intermediate processes illustrated in FIG. 4E, 5D, or 5E2). At step 608, the method may include epitaxially growing source/drain regions at opposing ends of the channel patterns of the first and/or second transistors (e.g., the intermediate processes illustrated in FIGS. 3F, 4D, 4F, 5E1, 5E2, 5F1, and/or 5F2). At step 610, the method may include replacing the sacrificial gate patterns with the conductive gate patterns between the source/drain regions (or between the inner spacers) (e.g., the intermediate processes illustrated in FIGS. 3F, 4F, 5F1, or 5F2).

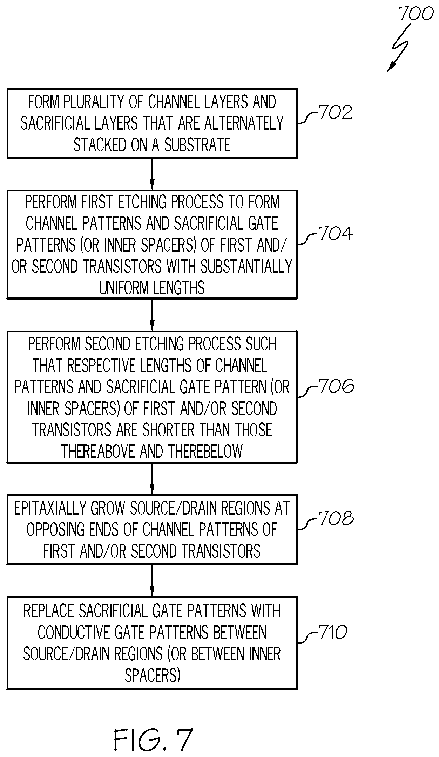

FIG. 7 is a flowchart 700 illustrating a method of forming the integrated circuit device according to some embodiments. The method illustrated in flowchart 700 may correspond to intermediate process diagrams described above either alone or in combination, such as a combination of intermediate process diagrams illustrated by FIGS. 4A-4F, 5A-5D, 5E1, 5E2, 5F1, and/or 5F2. It should be understood that certain steps may not be performed in various embodiments, and the order of the steps for forming the semiconductor integrated circuit device are not limited to the examples illustrated and described herein

At step 702, the method may include forming a plurality of channel layers and sacrificial layers that are alternately stacked on a substrate (e.g., the intermediate process illustrated in FIG. 4A, or 5A). At step 704, the method may include performing a first etching process (e.g., one or more anisotropic etching processes) to form channel patterns and sacrificial gate patterns (and optionally, inner spacers at opposing ends thereof) for first and/or second transistors (e.g., lower and upper transistors that are stacked on the substrate) with substantially uniform lengths (e.g., the intermediate processes illustrated FIGS. 4A-4B or 5A-5B). At step 706, the method may include performing a second etching process (e.g., one or more bowl etching processes) such that the respective lengths of the middle channel patterns and the middle sacrificial gate patterns (and optionally, the middle inner spacers) of at least one of the first and/or second transistors are shorter than those thereabove/therebelow (e.g., the intermediate processes illustrated in FIGS. 4E, 5D, or 5E2). At step 708, the method may include epitaxially growing source/drain regions at opposing ends of the channel patterns of the first and/or second transistors (e.g., the intermediate processes illustrated in FIGS. 3F, 4D, 4F, 5E1, 5E2, 5F1, and/or 5F2). At step 710, the method may include replacing the sacrificial gate patterns with the conductive gate patterns between the source/drain regions (or between the inner spacers) (e.g., the intermediate processes illustrated in FIGS. 4F, 5F1, or 5F2).

Due to the tapered etch processes and/or bowl etching processes as described herein, the channel lengths, gate lengths, and/or inner spacer thicknesses of the upper device (and/or the lower device) may be independently controlled and may differ as desired to provide differing characteristics of the upper and lower devices of a stacked transistor structure. Advantages of structures, features, or operations for upper and lower device formation as described herein may include, for example, fabrication of upper and lower transistors in a stacked transistor structure such that the lengths of the gates, channels, and/or inner spacers may be independently adjusted, which can improve or optimize the performance of the stacked transistor (e.g., CMOS). For example, the stacked transistors may have reduced leakage current and improved performance through NFET short channel effect (SCE) improvement. Also, the stacked transistors may have improved performance through PFET junction optimization. However, embodiments of the present disclosure are not limited thereto.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, each example embodiment is described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of stated features, steps, operations, elements and/or components, but do not preclude the presence or addition of one or more other features, steps, operations, elements, components and/or groups thereof.

It will be understood that, although the terms "first," "second," etc. are used throughout this specification to describe various elements, these elements should not be limited by these terms. These terms are only used to distinguish one element from another. For example, a first element could be termed a second element, and, similarly, a second element could be termed a first element, without departing from the scope of the present disclosure. The term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Spatially relative terms such as "below" or "above" or "upper" or "lower" or "top" or "bottom" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the disclosure should not be construed as limited to the example embodiments set forth herein. As such, it will be understood by those of ordinary skill in the art that various changes in form and details may be made therein without departing from the spirit and scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the present disclosure are also described with reference to a fabrication operations and flowchart diagrams. It will be appreciated that the steps shown in the fabrication operations and flowchart diagrams need not be performed in the order shown.

## Claims

1. An integrated circuit device comprising:
a substrate (106); and
a stacked transistor structure (101) on the substrate (106), the stacked transistor structure (101) comprising a first transistor (102) and a second transistor (104; 204) stacked on the first transistor (102),
wherein each of the first transistor (102) and the second transistor (104; 204) comprises one or more channel patterns (108, 110; 108, 210) that extend between source/drain regions (114, 116; 114, 216) in a first direction (D1) and are alternately stacked with one or more gate patterns (107) in a second direction (D3), and
wherein, for at least one of the first and second transistors (102, 104; 102, 204), respective lengths of the channel patterns (108, 110; 108, 210) and the gate patterns (107) differ along the first direction (D1).

2. The integrated circuit device of Claim 1, wherein the at least one of the first and second transistors (102, 104) is the second transistor (104), and the respective lengths of the channel patterns (110) of the second transistor (104) are shorter than that of the channel patterns (108) of the first transistor (102).

3. The integrated circuit device of Claim 1, wherein for the at least one of the first and second transistors (102, 204), the respective length (L_{210-M2}) of at least one (210-M2) of the channel patterns (210) is shorter than that of ones of the channel patterns thereabove and therebelow in the second direction (D3).

4. The integrated circuit device of Claim 1 or 3, wherein the at least one of the first and second transistors (102, 204) comprises inner spacers (212) between opposing ends of the gate patterns (107) and the source/drain regions (216) thereof in the first direction (D1), and
wherein, for the at least one of the first and second transistors (102, 104), respective lengths of the inner spacers (212) differ along the first direction (D1).

5. The integrated circuit device of Claim 4, wherein the at least one of the first and second transistors (102, 204) is the second transistor (204), and the respective lengths of the inner spacers (212) of the second transistor (204) are shorter than that of inner spacers (112) of the first transistor (102).

6. The integrated circuit device of Claim 4 or 5, wherein for the at least one of the first and second transistors (102, 204), the respective length of at least one of the inner spacers (212) is shorter than that of ones of the inner spacers thereabove and therebelow in the second direction.

7. The integrated circuit device of Claims 1 or 2, wherein, for the at least one of the first and second transistors (102, 104), respective lengths of the channel patterns (108, 110) and the gate patterns (107) differ along the first direction (D1).

8. The integrated circuit device of Claim 7, wherein the at least one of the first and second transistors (102, 104) is the second transistor (104), and the respective lengths of the gate patterns (107) of the second transistor (104) are shorter than that of the gate patterns (107) of the first transistor (102).

9. The integrated circuit device of Claim 1 to 8, wherein, for the at least one of the first and second transistors (102, 204), the respective length (L_{207-M2}) of at least one of the gate patterns (207) is shorter than that of ones of the gate patterns thereabove and therebelow in the second direction (D3).

10. A method of forming an integrated circuit device, the method comprising:
forming a stacked transistor structure (101) on a substrate (106), the stacked transistor structure (101) comprising a first transistor (102) and a second transistor (104; 204) stacked on the first transistor (102),
wherein each of the first transistor (102) and the second transistors (104; 204) comprises one or more channel patterns (108, 110; 108, 210) that extend between source/drain regions (114, 116; 114, 216) in a first direction (D1) and are alternately stacked with one or more gate patterns (107) in a second direction (D3), and
wherein, for at least one of the first and second transistors (102, 104; 102, 204), respective lengths of the channel patterns (108, 110; 210) and the gate patterns (107) differ along the first direction (D1).

11. The method of Claim 10, wherein forming the stacked transistor structure (101) comprises:
forming a plurality of channel layers (302; 402) that are stacked on a substrate (106); and
performing at least one etching process on the plurality of channel layers (302; 402) to form the channel patterns (108, 110; 210) of the at least one of the first and second transistors (102, 104; 102, 204) with the respective lengths that differ along the first direction (D1).

12. The method of Claim 11, wherein performing the at least one etching process comprises:
performing a tapered etching process on the plurality of channel layers (302; 402) such that the respective length (L_{210-M2}) of at least one of the channel patterns (210-M2) of the second transistor (204) is shorter than that of at least one of the channel patterns (108) of the first transistor (102) by 10 percent or more.

13. The method of Claim 11 or 12, wherein performing the at least one etching process comprises:
performing a first etching process on the plurality of channel layers (302; 402); and
performing a bowl etching process on the channel patterns (210) of the at least one of the first and second transistors (204) such that the respective length of at least one of the channel patterns (210-M2) is shorter than that of ones of the channel patterns thereabove and therebelow in the second direction (D3).

14. The method of Claim 13, wherein the at least one of the first and second transistors (102, 204) is the second transistor (204), and further comprising:
after performing the first etching process, epitaxially growing the source/drain regions (114) of the first transistor (102) at the opposing ends of the channel patterns (108) thereof;
forming an etch stop layer (122) on the source/drain regions (114) of the first transistor (102) before performing the bowl etching process on the channel patterns (210) of the second transistor (204); and
after performing the bowl etching process, epitaxially growing the source/drain regions (216) of the second transistor (104) at the opposing ends of the channel patterns (210) thereof.

15. The method of Claim 14, wherein the gate patterns (107) of the second transistor (204) comprise sacrificial gate patterns (408) having inner spacers (212) at opposing ends thereof, and wherein, responsive to the bowl etching process, a respective length of at least one of the inner spacers (212) is shorter than that of ones of the inner spacers thereabove and therebelow in the second direction (D3), or
wherein the gate patterns (107) of the second transistor (204) comprise sacrificial gate patterns that are free of inner spacers at opposing ends thereof, and wherein, responsive to the bowl etching process, the respective length of at least one of the sacrificial gate patterns is shorter than that of ones of the sacrificial gate patterns thereabove and therebelow in the second direction.
